# EUROPEAN PATENT SPECIFICATION

(11) **EP 4 413 601 B1**
(45) Date of publication and mention of the grant of the patent: **30.07.2025**
(21) Application number: 22789704.8
(22) Date of filing: 26.09.2022
(51) Int. Cl.: H01G 9/20

(54) **PHOTOELECTRIC CONVERSION DEVICE, ELECTRONIC DEVICE, AND POWER SUPPLY MODULE**
PHOTOELEKTRISCHE UMWANDLUNGSVORRICHTUNG, ELEKTRONISCHE VORRICHTUNG UND STROMVERSORGUNGSMODUL
DISPOSITIF DE CONVERSION PHOTOÉLECTRIQUE, DISPOSITIF ÉLECTRONIQUE ET MODULE D'ALIMENTATION ÉLECTRIQUE

(30) Priority: 07.10.2021 JP 2021165183
(43) Date of publication of application: 14.08.2024
(73) Proprietor: Ricoh Company, Ltd., Tokyo 143-8555 (JP)
(72) Inventor: ARAI, Ryota, Tokyo 143-8555 (JP); ITO, Takaya, Tokyo 143-8555 (JP); HIRANO, Tomoya, Tokyo 143-8555 (JP); KOMITO, Kenji, Tokyo 143-8555 (JP)
(74) Representative: Marks & Clerk LLP
(86) International application number: PCT/JP2022/035738
(87) International publication number: WO 2023/058490

(56) References cited:
- EP-A1- 3 855 523
- LI CHANG ET AL: "Ternary organic solar cells based on ZnO-Ge double electron transport layer with enhanced power conversion efficiency", SOLAR ENERGY, vol. 155, 15 July 2017 (2017-07-15), pages 1052 - 1058, XP085233189, ISSN: 0038-092X, DOI: 10.1016/J.SOLENER.2017.07.053
- FAN PU ET AL: "Polymer-Modified ZnO Nanoparticles as Electron Transport Layer for Polymer-Based Solar Cells", ADVANCED FUNCTIONAL MATERIALS, vol. 30, no. 32, 21 June 2020 (2020-06-21), DE, pages 2002932, XP093005303, ISSN: 1616-301X, Retrieved from the Internet <URL:https://onlinelibrary.wiley.com/doi/full-xml/10.1002/adfm.202002932> [retrieved on 20221206], DOI: 10.1002/adfm.202002932
- YANMING SUN ET AL: "Inverted Polymer Solar Cells Integrated with a Low-Temperature-Annealed Sol-Gel-Derived ZnO Film as an Electron Transport Layer", ADVANCED MATERIALS, VCH PUBLISHERS, DE, vol. 23, no. 14, 22 February 2011 (2011-02-22), pages 1679 - 1683, XP071810165, ISSN: 0935-9648, DOI: 10.1002/ADMA.201004301

## Description

### Technical Field

The present invention relates to a photoelectric conversion device, an electronic device, and a power supply module.

### Background Art

In recent years, realization of an Internet of Things (IoT) society, in which everything is connected to an internet thereby enabling comprehensive control, has been expected. To realize such IoT society, a large number of sensors are required to be attached to various devices to acquire data; then, for this, a power supply to run the large number of sensors is required. Wiring to the large number of sensors and the use of batteries are not practical; on top of this, from a growing social need to reduce an environmental impact, a power supply by an environmental power generating device is wanted.

Among these, the photoelectric conversion device is attracting an attention as the device that can generate an electricity wherever light is available. In particular, a flexible photoelectric conversion device is expected to have a high efficiency and to be able to follow various situations; thus, it is expected to be suitably applicable for a wearable device and the like.

For example, Non-patent Literatures 1 and 2 report the result of a feasibility study of the photoelectric conversion device for a wearable device.

In general, an organic thin film solar cell is expected to be an environmental power generating device having a high efficiency as well as flexibility; and a photoelectric conversion device using a transparent base film as the base has been proposed in Patent Literature 1. Li Chang et al.,Ternary organic solar cells based on ZnO-Ge double electron transport layer with enhanced power conversion efficiency", SOLAR ENERGY, vol. 155, p. 1052-1058, discloses a photoelectric conversion device comprising an electron transport layer comprising ZnO particles.

### Summary of Invention

### Technical Problem

However, when light is irradiated to the photoelectric conversion device for a long time, there is a problem in that the photoelectric conversion efficiency after light irradiation decreases as compared to the photoelectric conversion efficiency at the start of light irradiation.

### Solution to Problem

According to an aspect of the present invention, a photoelectric conversion device includes a photoelectric conversion layer, and an electron transport layer. The electron transport layer includes metal oxide particles. In response to performing an X-ray photoelectron spectroscopy (XPS) analysis on the electron transport layer, two peaks representing 1s orbitals of oxygen atoms are detected. A formula Y/(X+Y)≧0.5 is satisfied, where a peak area of a peak on a low-energy side among the two peaks is X and a peak area of a peak on a high-energy side among the two peaks is Y.

### Advantageous Effects of Invention

According to an aspect of the present invention, it is possible to provide a photoelectric conversion device in which a decrease in the photoelectric conversion efficiency after light irradiation can be suppressed as compared to the photoelectric conversion efficiency at the start of light irradiation, even when the photoelectric conversion device is irradiated with light for a long time.

### Brief Description of Drawings

[Fig.1]Fig. 1 is an overlooking schematic view of one example illustrating the photoelectric conversion device.
[Fig.2]Fig. 2 is a sectional schematic view of one example illustrating the photoelectric conversion device.
[Fig.3A]Fig. 3A is a schematic view illustrating one example illustrating the production method of the photoelectric conversion module.
[Fig.3B]Fig. 3B is a schematic view illustrating one example illustrating the production method of the photoelectric conversion module.
[Fig.3C]Fig. 3C is a schematic view illustrating one example illustrating the production method of the photoelectric conversion module.
[Fig.3D]Fig. 3D is a schematic view illustrating one example illustrating the manufacturing method of the photoelectric conversion module.
[Fig.3E]Fig. 3E is a schematic view illustrating one example illustrating the manufacturing method of the photoelectric conversion module.
[Fig.3F]Fig. 3F is a schematic view illustrating one example illustrating the producing method of the photoelectric conversion module.
[Fig.3G]Fig. 3G is a schematic view illustrating one example illustrating the producing method of the photoelectric conversion module.
[Fig.3H]Fig. 3H is a schematic view illustrating one example illustrating the producing method of the photoelectric conversion module.
[Fig.3I] Fig. 3I is a schematic view illustrating one example illustrating the producing method of the photoelectric conversion module.
[Fig.3J]Fig. 3J is a schematic view of one example illustrating the production method of the photoelectric conversion module.
[Fig.3K]Fig. 3K is a schematic view of one example illustrating the production method of the photoelectric conversion module.
[Fig.4]Fig. 4 is a schematic diagram of one example illustrating the basic configuration of an electronic device.
[Fig.5]Fig. 5 is a schematic diagram of one example illustrating the basic configuration of an electronic device.
[Fig.6]Fig. 6 is a schematic diagram of one example illustrating the basic configuration of an electronic device.
[Fig.7]Fig. 7 is a schematic diagram of one example illustrating the basic configuration of a power supply module.
[Fig.8]Fig. 8 is a schematic diagram of one example illustrating the basic configuration of a power supply module.
[Fig.9]Fig. 9 is a schematic diagram of one example illustrating the basic configuration of a personal computer mouse.
[Fig.10]Fig. 10 is a schematic appearance of one example of a personal computer mouse illustrated in Fig. 9.
[Fig.11] Fig. 11 is a schematic diagram of one example illustrating the basic configuration of a personal computer keyboard.
[Fig.12] Fig. 12 is a schematic appearance of one example illustrating the personal computer keyboard illustrated in Fig. 11.
[Fig.13] Fig. 13 is a schematic appearance of another example illustrating the personal computer keyboard illustrated in Fig. 11.
[Fig.14] Fig. 14 is a schematic diagram of one example illustrating the basic configuration of a sensor.
[Fig.15] Fig. 15 is a schematic diagram of one example illustrating wireless communication to transmit the data acquired by a sensor to a personal computer, a smartphone, or other device.
[Fig.16] Fig. 16 is a schematic diagram of one example illustrating the basic configuration of a turntable.

### Description of Embodiments

<<Photoelectronic Conversion Device Relating to Organic Thin Film Solar Cell>> "The photoelectric conversion device" is the device that converts a light's energy into an electrical energy or an electrical energy into a light's energy. Specifically, examples thereof include the device composed of a solar cell, and a photodiode. Illustrative examples of the solar cell include an organic thin film solar cell. In the present disclosure, the photoelectric conversion device, which is a component of the organic thin film solar cell, will be described.

The photoelectric conversion device has at least a photoelectric conversion layer, specifically, a first electrode, an electron transport layer, a photoelectric conversion layer, and a second electrode in sequence. The term "in sequence" means that the electrodes and the layer are arranged in the above order as a whole, while other layers or the like may be inserted between the electrodes and the layer. Examples for the case in which other layers are inserted include the photoelectric conversion device having a first electrode, an electron transport layer, a photoelectric conversion layer, a hole transport layer, and a second electrode in sequence, as well as the photoelectric conversion device having a first electrode, an electron transport layer, an intermediate layer, a photoelectric conversion layer, a hole transport layer, and a second electrode in sequence. In this case, on top of this, other layers or the like may be inserted between the electrode and the layer or between the layers. The term "in sequence" indicates here that these electrodes and layers may be stacked sequentially from the first electrode or from the second electrode. Specifically, when viewed from the incidence plane side, the photoelectric conversion device may be stacked sequentially in the order of the first electrode, the electron transport layer, the photoelectric conversion layer, and the second electrode, or in the order of the second electrode, the photoelectric conversion layer, the electron transport layer, and the first electrode. When the photoelectric conversion device has the hole transport layer, when viewed from the incidence plane side, the photoelectric conversion device may have the configuration in which the first electrode, the electron transport layer, the photoelectric conversion layer, the hole transport layer, and the second electrode are sequentially stacked in this order, or the configuration in which the second electrode, the hole transport layer, the photoelectric conversion layer, the electron transport layer, and the first electrode are sequentially stacked in this order. When the photoelectric conversion device has the hole transport layer and the intermediate layer, when viewed from the incidence plane side, the photoelectric conversion device may have the configuration in which the first electrode, the electron transport layer, the intermediate layer, the photoelectric conversion layer, the hole transport layer, and the second electrode are sequentially stacked in this order, or the configuration in which the second electrode, the hole transport layer, the photoelectric conversion layer, the intermediate layer, the electron transport layer, and the first electrode are sequentially stacked in this order. In the present disclosure, the explanation will be mainly given to the case in which the first electrode, the electron transport layer, the intermediate layer, the photoelectric conversion layer, the hole transport layer, and the second electrode are stacked sequentially in this order when viewed from the incidence plane side, but this photoelectric conversion device is not limited to the case like this. From the description above, a person ordinarily skilled in the art can easily understand another aspect such as a case in which the second electrode, the hole transport layer, the photoelectric conversion layer, the intermediate layer, the electron transport layer, and the first electrode are stacked sequentially in this order when viewed from the incidence plane side.

The photoelectric conversion device has, as needed, a base, a surface protection portion, a sealing member, a UV-cut layer, and the like.

In the cases of the first electrode and the second electrode, the electrode located far from the light incident plane of the photoelectric conversion device is referred to as "one electrode" and the electrode located near to the light incident plane of the photoelectric conversion device is referred to as "the other electrode", when the photoelectric conversion device has a base, the base is preferably arranged closer to a surface of the other electrode, the surface not facing the photoelectric conversion layer. Namely, it is preferable that the photoelectric conversion device have, when viewed from the incidence plane side, the configuration in which, for example, the base, the first electrode, the electron transport layer, the intermediate layer, the photoelectric conversion layer, the hole transport layer, and the second electrode are stacked sequentially in this order, or the configuration in which the base, the second electrode, the hole transport layer, the photoelectric conversion layer, the intermediate layer, the electron transport layer, and the first electrode are stacked sequentially in this order.

### <Base>

The "base" is the member that supports the electrodes, the layers, and the like, that constitute the photoelectric conversion device. From a viewpoint to enhance the photoelectric conversion efficiency, it is preferable that the base be high in light permeability, while more preferably transparent. In addition, from a viewpoint to widen the application thereof, it is preferable that the base have high flexibility.

Illustrative examples of the transparent and flexible base include resin films of polyesters such as polyethylene terephthalate (PET), a polycarbonate, a polyimide, a polymethyl methacrylate, a polysulfone, a polyether ether ketone, as well as a thin glass film (glass having the thickness of 200 µm or less). Among these materials, from viewpoints of easy production and cost, resin films of a polyester and of a polyimide, as well as a thin glass film are preferable. When the resin film or the thin glass film is used as the base, the thickness of the base is preferably 200 µm or less. When the base has the thickness of 200 µm or less, the flexibility thereof is enhanced so that the durability thereof can be improved as well, even when the photoelectric conversion device is bent. The thickness of the base can be measured by a publicly known method, for example, using a contact-type thickness gauge.

Illustrative examples of the material for the base having transparency but lacking flexibility include an inorganic transparent crystalline material such as a glass other than the thin glass film (in other words, a glass having the thickness of more than 200 µm). These materials are preferable because they are not flexible but highly flat.

It is preferable that the base have a gas barrier property. The gas barrier property relates to a function to inhibit the permeation of a water vapor, oxygen, and the like. In the present disclosure, the "base having a gas barrier property" is not limited to those in which the base itself has the gas barrier property; but this also includes those having a gas barrier layer, which is the layer having the gas barrier property, at the position adjacent to the base. The base having the gas barrier property can provide the photoelectric conversion device having a high storage durability, in which the decrease in the photoelectric conversion efficiency can be further suppressed even when the device is placed in a high temperature and high humidity environment for a long time. The gas barrier layer is to be described later.

In general, the function that is required for the base having the gas barrier property is expressed in terms of a water vapor permeability, an oxygen permeability, and the like. The water vapor permeability per day in accordance with the JIS K7129 B method is preferably, for example, 10 g/m² or less, although the lower the better. The oxygen permeability per day in accordance with JIS K7126-2 is preferably, for example, 1 cm³/m² • atm or less, although the lower the better.

As for the resin film having the gas barrier property, publicly known films can be used as appropriate. Examples thereof include an aluminum-coated resin film, and a silicon oxide-coated resin film.

### <First Electrode>

The "first electrode" is the electrode that collects electrons generated by photoelectric conversion. When the first electrode is arranged closer to the incidence plane, from a viewpoint to enhance the photoelectric conversion efficiency, it is preferable that the first electrode be high in light permeability, while more preferably transparent. However, when the first electrode is arranged opposite to the incidence plane, this may be low in the light permeability and transparency.

As for the first electrode having transparency, a transparent electrode that is transparent to a visible light can be used. The transparent electrode is, for example, a structural body composed of a transparent conductive film, a metal thin film, and a transparent conductive film in sequence. The two transparent conductive films having the metal thin film interposed therebetween may be formed from the same material or from different materials.

Illustrative examples of the material for the transparent conductive film include a tin-doped indium oxide (ITO), a zinc-doped indium oxide (IZO), a zinc oxide (ZnO), a fluorine-doped tin oxide (FTO), an aluminum-doped zinc oxide (AZO), a gallium-doped zinc oxide (GZO), a tin oxide (SnO2), a silver nanowire, and a nanocarbon (carbon nanotube, graphene, or the like). Among these materials, a tin-doped indium oxide (ITO), a zinc-doped indium oxide (IZO), and an aluminum-doped zinc oxide (AZO) are preferable.

Illustrative examples of the material for the metal thin film include thin films formed from metals such as aluminum, copper, silver, gold, platinum, and nickel.

From a viewpoint of maintaining rigidity, the first electrode that has transparency and is integrated with the base described before is preferably used. Illustrative examples thereof include an FTO-coated glass, an ITO-coated glass, an aluminum-coated glass, an FTO-coated transparent plastic film, an ITO-coated transparent plastic film, and a plastic film coated with an ITO/silver/ITO laminate.

Illustrative examples of the material for the non-transparent first electrode include metals such as platinum, gold, silver, copper, and aluminum, as well as graphite.

The average thickness of the first electrode is preferably 5 nm or more and 10 µm or less, while more preferably 50 nm or more and 1 µm or less.

The sheet resistance of the first electrode is preferably 50 Ω/sq. or less, and more preferably 30 Ω/sq. or less, while still more preferably 20 Ω/sq. or less.

When the first electrode is transparent, the light transmittance of the first electrode is preferably 60% or greater, more preferably 70% or greater, and still more preferably 80% or greater, while especially preferably 90% or greater. There is no particular restriction in the upper limit thereof; so, this can be selected as appropriate in accordance with the purpose.

The first electrode may be formed by a wet coating method, a dry coating method such as a vapor deposition method and a sputtering method, and a printing method.

### <Electron Transport Layer>

The "electron transport layer" is the layer that transports an electron generated in the photoelectric conversion layer and inhibits the entry of a hole generated in the photoelectric conversion layer, and that contains metal oxide particles. The electron transport layer may have a structure consisting of one layer, or two or more layers.

The electron transport layer is a layer containing the metal oxide particles, which are particles containing metal oxide as a constituent material, as described above.

Illustrative examples of the metal oxide include oxides of titanium, zinc, lithium, and tin, as well as ITO, FTO, ATO, AZO, and GZO. Among these, zinc oxide, titanium oxide, or tin oxide is preferable, more preferable is a zinc oxide, while still more preferable is a zinc oxide that is doped in order to enhance the conductivity. Illustrative Examples of the doped zinc oxide include an aluminum-doped zinc oxide, a gallium-doped zinc oxide, and a lithium-doped zinc oxide. Also, the metal oxide may be made from a metal alkoxide or the like as the raw material thereof.

The "metal oxide" in the present disclosure needs only to contain metal oxide as the constituent material, and may be either a doped or undoped metal oxide, as described above.

The number-average particle diameter of the metal oxide particles is preferably 10 nm or more and 50 nm or less, more preferably 10 nm or more and 40 nm or less, while still more preferably 10 nm or more and 20 nm or less. When the number-average particle diameter of the metal oxide particles is 10 nm or more to 50 nm or less, the thickness of the electron transport layer becomes within a proper range.

The number-average particle diameter of the metal oxide particles is obtained, for example, by measuring the diameters of at least 100 randomly selected particles of the metal oxide by the method described below to calculate the average value of these measured values. First, a dispersion liquid containing metal oxide particles is transferred to a glass nebulizer by using a micropipette. Next, the dispersion liquid is sprayed from a nebulizer onto a grid attached with a collodion membrane for TEM. Using a PVD method, the grid is vapor-deposited with carbon, and an image of the metal oxide particles is obtained by an electron microscopy. The resulting image is image-processed to measure the particle diameter of the metal oxide particle. Specifically, the diameter of a circle with an area equivalent to the area of the metal oxide particle in the obtained image is defined as the diameter of the metal oxide particle, and those having a particle diameter of 5 nm or more are used. The particle diameter of the metal oxide particle may also be measured by observing the cross-section of the photoelectric conversion device using a scanning transmission electron microscope (TEM) followed by particle recognition using the image processing. The particle size distribution may also be measured by a laser diffraction and scattering method. Cutting out of the cross section of the photoelectric conversion device, observation by TEM, and measurement of particle size distribution can be done by a publicly known method.

As stated above, "metal oxide particles" in the present disclosure shall refer to those having the particle diameter of 5 nm or more, and shall not include those having the particle diameter of less than 5 nm.

The average thickness of the electron transport layer is preferably 10 nm or more and 300 nm or less, while more preferably 10 nm or more and 100 nm or less.

Examples of the production method of the electron transport layer include a method of using a dispersion liquid containing metal oxide particles and a dispersing medium, and a solution containing a metal oxide precursor, which is a precursor of a metal oxide, and a solvent.

The above dispersion liquid is used to arrange the above metal oxide particles that constitute the electron transport layer.

Illustrative examples of the dispersing medium include alcohols such as methanol, ethanol, isopropanol (2-propanol), 1-propanol, 2-methoxyethanol, and 2-ethoxyethanol, as well as mixtures thereof.

The above solution is used to arrange the metal oxide film that constitutes the electron transport layer on the basis of the method in which the metal oxide precursor is transformed into the metal oxide by applying an external stimulation such as heat or light (sol-gel method). In the present disclosure, "metal oxide film" means a structural body of the metal oxide that contains metal oxide as the constituent material and is located between a plurality of metal oxide particles (in other words, a structural body of the metal oxide that exists to fill the space formed between a plurality of metal oxide particles) and, as described above, as an example, is derived from the metal oxide precursor contained in the solution. The metal oxide film may be a structural body of continuous metal oxide or an aggregation of metal oxide fine particles. The case of the aggregation of metal oxide fine particles indicates the concept that the metal oxide fine particles are not included in the above metal oxide particles, specifically the particles having a diameter of 5 nm.

The metal oxide, which is the constituent material of the metal oxide film, can be the same material as that exemplified above as the metal oxide that is the constituent material of the metal oxide particles; here, illustrative examples thereof include oxides of titanium, zinc, lithium, and tin, and among these oxides, zinc oxide is preferable. It is preferable that the metal oxide film and metal oxide particles contain the same metal oxide as the constituent material, and that both contain zinc oxide as the constituent material. When the metal oxide that is the constituent material of the metal oxide film is zinc oxide, for example, zinc acetate may be used as the metal oxide precursor. Illustrative examples of the solvent include 2-ethanolamine and 2-methoxyethanol, as well as a mixture of these solvents.

A specific production method of the electron transport layer includes, for example, a process at which the above dispersion liquid is applied followed by arranging the metal oxide by drying this as necessary, and a process at which after applying the above solution on the arranged metal oxide particles, the metal oxide precursor is changed to the metal oxide by means of the external stimulation to form the metal oxide film.

Another specific production method of the electron transport layer includes, for example, a process at which a mixed liquid of the component (metal oxide particles) in the dispersion liquid with the component (metal oxide precursor) in the solution is prepared, and then, after the mixed liquid is applied, the metal oxide particles are arranged by drying this as necessary, and further, the metal oxide precursor is changed to the metal oxide by means of the external stimulation to form the metal oxide film.

Hereinafter, the reason why it is preferable to use the dispersion liquid and the solution in production of the electron transport layer.

Conventionally, only the above dispersion liquid has been generally used in the production of the electron transport layer. However, when the electron transport layer is produced using only the dispersion liquid, during prolonged use of the photoelectric conversion device, the material of the layer adjacent to the electron transport layer (such as the photoelectric conversion layer to be described later) enters into the space between the metal oxide particles thereby causing the material to contact with the first electrode, resulting in deterioration of the electron transport property and the hole penetration inhibitory property (hole blocking property) of the electron transport layer; thus, there has been the problem that the photoelectric conversion efficiency of the photoelectric conversion device deteriorates over time when the photoelectric conversion device is exposed to light for an extended period of time.

On the contrary, when the solution is used in addition to the dispersion liquid in the production of the electron transport layer, the space between the metal oxide particles arranged by the use of the dispersion liquid can be filled by the metal oxide film formed by using the solution, thereby leading to suppression of the material of the layer adjacent to the electron transport layer from entering into the space, resulting in suppression of the photoelectric conversion efficiency of the photoelectric conversion device from deterioration over time when the photoelectric conversion device is exposed to light for an extended period of time.

When the X-ray photoelectron spectroscopy (XPS) analysis is performed on the electron transport layer produced using the dispersion liquid and solution, two peaks representing the 1s orbitals of the oxygen atoms are detected, and the formula "Y/ (X+Y)≧0.5" is satisfied, where the peak area of the peak on the low-energy side among the two peaks is X and the peak area of the peak on the high- energy side among the two peaks is Y, .

When this analysis is performed on the electron transport layer produced using only the dispersion liquid as in the case of the conventional method, the formula "Y/ (X+Y)≧0.5" is not satisfied; thus, the difference in the production method of the electron transport layer can be judged as the difference in the analysis result of the electron transport layer. In other words, when the formula "Y/(X+Y)≧0.5" is satisfied, the photoelectric conversion efficiency of the photoelectric conversion device can be suppressed from deterioration over time when the photoelectric conversion device is exposed to light for an extended period of time.

In the present disclosure, when the X-ray photoelectron spectroscopy (XPS) analysis is performed on the electron transport layer, the formula "Y/(X+Y)≧0.5" is satisfied; but it is preferable to satisfy the formula "0.8≧Y/(X+Y)≧0.5", while more preferably to satisfy the formula "0.7≧Y/(X+Y)≧0.5".

The details of the X-ray photoelectron spectroscopy (XPS) analysis performed on the electron transport layer are described below. Here, a specific example will be described in which the constituent material of the metal oxide particles in the dispersion liquid is zinc oxide, the metal oxide precursor in the solution is zinc acetate, and the constituent material of the metal oxide film formed by the sol-gel method using this solution is zinc oxide. In this case, of the two peaks representing the 1s orbitals of the oxygen atoms, the peak on the high-energy side has a peak top at 532 ± 1 eV, and the peak on the low-energy has a peak top at 530 ± 1 eV. The peak on the high-energy side is considered to be the peak derived from the hydroxyl group, while the peak on the low-energy side is considered to be the peak derived from the oxygen atom of zinc oxide. In the present disclosure, when the peak area (X) of the peak on the low-energy and the peak area (Y) of the peak on the high-energy side are compared, there is a characteristic that the peak area (Y) of the peak on the high-energy side is predominant (larger), in other words, with respect to the state of the oxygen atoms, the one derived from the hydroxyl group is predominant. This hydroxyl group indicates that the transformation of the metal oxide precursor contained in the solution to the metal oxide by means of the external stimulation is incomplete; so, if the electron transport layer contains the metal oxide film and the metal oxide particles in such a state, it is possible to suppress the photoelectric conversion efficiency of the photoelectric conversion device from deterioration over time when the photoelectric conversion device is exposed to light for an extended period of time.

The ratio of the peak area (X) of the peak on the low-energy side and the peak area (Y) of the peak on the high-energy side may be controlled (in other words, the value of "Y/(X+Y)" may be controlled) by the method in which the degree of the external stimulation that changes the metal oxide precursor to the metal oxide is controlled, specifically, by controlling the firing temperature. For example, the peak area (Y) of the peak on the high-energy side tends to increase when fired at the temperature below 150°C, while the peak area (X) of the peak on the low-energy side tends to increase when fired at the temperature of 150°C or higher (especially 200°C or higher).

The X-ray photoelectron spectroscopy (XPS) analysis can be performed on the electron transport layer using, for example, K-Alpha (manufactured by Thermo Fisher Scientific Inc.).

The peak separation process can be performed using the analysis software (e.g., CasaXPS) provided by the X-ray photoelectron spectrometer. Specifically, the analysis is performed in the bonding energy range of the elemental spectrum of interest, using the prescribed peak separation and fitting functions of the software. The separation conditions are not particularly restricted as long as the method can perform the analysis with good reproducibility. The peak abundance for each bonding state can be calculated by calculating the peak area for each of the spectra of the peaks which are separated as to the element of interest. The conditions for calculating the peak abundance are not particularly restricted as long as the analysis can be done with good reproducibility.

### <Intermediate Layer>

The "intermediate layer" is the layer that transports an electron generated in the photoelectric conversion layer and inhibits the entry of a hole generated in the photoelectric conversion layer, and that does not contain the metal oxide particles. The intermediate layer may have a structure consisting of one layer or of two or more layers.

The intermediate layer is preferably the layer containing an amine compound. The amine compound is preferably the material that can enhance the photoelectric conversion efficiency of the photoelectric conversion device by arranging the intermediate layer, and for example, an amine compound represented by the following general formula (4) can be used.

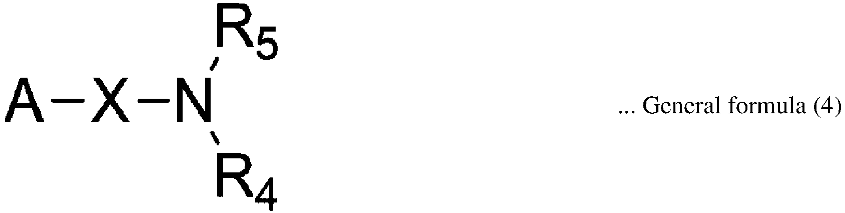

In the general formula (4), R₄ and R₅ each represent an optionally substituted alkyl group having the carbon number of 1 or more and 4 or less or a ring structure having R ₄ and R₅ bonded, in which the optionally substituted alkyl group having the carbon number of 1 or more and 4 or less is preferable, while a non-substituted alkyl group having the carbon number of 1 or more and 4 or less is more preferable. Illustrative examples of the substituent described above include a methyl group, an ethyl group, and a hydroxy group. The carbon number in the ring structure is preferably 3 or more and 6 or less. When R₄ and R₅ each are the optionally substituted alkyl group having the carbon number of 1 or more and 4 or less, the alkyl groups in R₄ and R₅ may be the same or different.

In the above general formula (4), X represents a divalent aromatic group having the carbon number of 6 or more and 14 or less or a divalent alkyl group having the carbon number of 1 or more and 4 or less, in which the divalent aromatic group having the carbon number of 6 or more and 14 or less is preferable.

In the above general formula (4), A represents any of the substituents represented by the following structural formulae (1) to (3), in which the substituent represented by the structural formula (1) is preferable.

-COOH ... Structural formula (1)

-P(=O)(OH)₂ ... Structural formula (2)

-Si(OH)₃ ... Structural formula (3)

Illustrative examples of the amine compound other than the general formula (4) include 3-aminopropyl triethoxysilane, 3-aminopropyl trimethoxysilane, 3-aminopropyl diethoxy methylsilane, 3-(2-aminoethylamino)propyl trimethoxysilane, 3-(2-aminoethylamino)propyl dimethoxy methylsilane, 3-(2-amino-ethylamino)propyl triethoxysilane, trimethoxy [3-(phenylamino)propyl]silane, trimethoxy [3-(methylamino)propyl]silane, bis[3-(trimethoxysilyl)propyl]amine, bis[3-(triethoxysilyl)propyl]amine, and
N,N'-bis[3-(trimethoxysilyl)propyl]ethane-1,2-diamine.

Illustrative examples of the method for producing the intermediate layer include a method of providing a solution containing the amine compound by a spin-coating method or a dipping method and of subsequently drying the solution.

### <Photoelectric Conversion Layer>

The "photoelectric conversion layer" is the layer that generates an electron and a hole by absorbing light. The photoelectric conversion layer contains two or more organic materials, specifically a donor organic material (also called a p-type organic semiconductor material) and an acceptor organic material (also called a n-type organic semiconductor material). Each of the donor and acceptor organic materials may be made of a plurality of organic materials, so that it is preferable that the photoelectric conversion layer contain three or more types of organic materials. In the photoelectric conversion layer, it is preferable that the donor and acceptor organic materials be mixed to form a bulk heterostructure.

### -Donor Organic Material-

The donor organic material is preferably a π-electron conjugated compound having a highest occupied molecular orbital (HOMO) level of 4.8 eV or more and 5.7 eV or less, while more preferably a π-electron conjugated compound having the level of 5.1 eV or more and 5.5 eV or less, or 5.2 eV or more 5.6 eV and less.

The highest occupied molecular orbital (HOMO) level can be obtained by measurement with a photoelectron yield spectroscopy, a cyclic voltammetry, or the like. Specifically, this may be measured using an instrument such as AC-3 manufactured by Riken Keiki Co., Ltd.

Illustrative examples of the donor organic material include a porphyrin and a phthalocyanine, which are conjugated polymers or low molecular weight conjugated compounds in which various aromatic derivatives (for example, thiophene, fluorene, carbazole, thienothiophene, benzodithiophene, dithienosilole, quinoxaline, and benzothiadiazole) are coupled. The donor organic material may also be a donor-acceptor linked material having an electron-donating moiety and an electron-accepting moiety in its molecular structure, among other materials.

The number-average molecular weight (Mn) of the donor organic material, when this is a low molecular weight molecule, is preferably 10,000 or less, while more preferably 5,000 or less. When the material is a polymer, the molecular weight thereof is preferably 10,000 or more.

In one preferable example of the donor organic material, the highest occupied molecular orbital (HOMO) level thereof is 5.1 eV or more and 5.5 eV or less and the number-average molecular weight (Mn) is 10,000 or less. Examples of the organic material like this include those compounds represented by the following general formula (1).

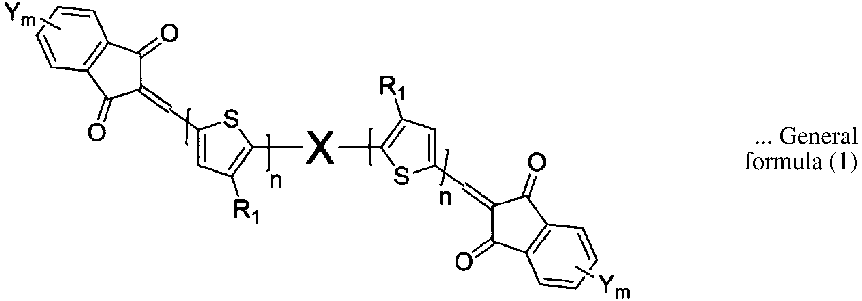

In the general formula (1) R₁ represents an alkyl group having the carbon number of 2 or more and 8 or less.

In the general formula (1), n represents an integer of 1 or more and 3 or less.

In the general formula (1), Y represents a halogen atom.

In the above general formula (1), m represents an integer of 0 or more and 4 or less.

In the general formula (1), X represents the following general formula (2) or the following general formula (3).

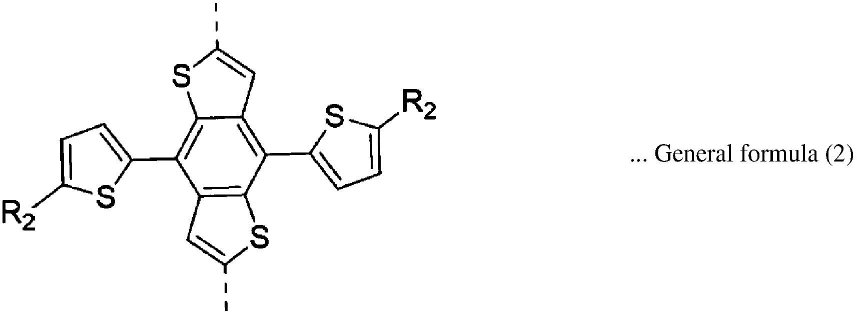

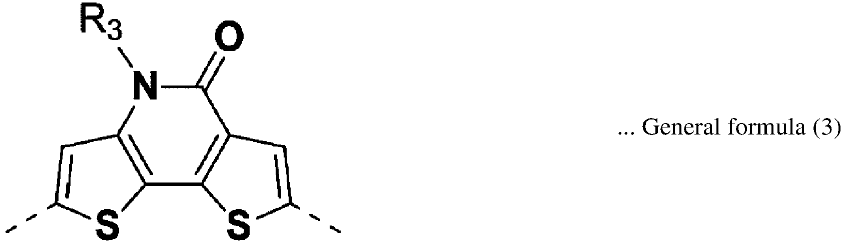

In the general formula (2), R₂ represents a linear or a branched alkyl group, preferably a linear or a branched alkyl group having the carbon number of 2 or more and 30 or less.

In the general formula (3), R₃ represents a linear or a branched alkyl group, preferably a linear or a branched alkyl group having the carbon number of 2 or more and 30 or less.

In another preferable example of the donor organic material, the highest occupied molecular orbital (HOMO) level is 5.2 eV or more and 5.6 eV or less and the number-average molecular weight (Mn) is 10,000 or more. Note that, it is preferable that this organic material be used in combination with the above-described organic material that has the highest occupied molecular orbital (HOMO) level of 5.1 eV or more and 5.5 eV or less and the number-average molecular weight (Mn) of 10,000 or less.

Illustrative examples of the organic material having the highest occupied molecular orbital (HOMO) level of 5.2 eV or more and 5.6 eV or less and the number-average molecular weight (Mn) of 10,000 or more include a 2,1,3-benzothiadiazole-thiophene type copolymer, a quinoxaline-thiophene type copolymer, a thiophene-benzodithiophene type copolymer, and a polyfluorene type polymer.

The 2,1,3-benzothiadiazole-thiophene type copolymer is represented by the conjugated copolymer having a thiophene skeleton and a 2,1,3-benzothiadiazole skeleton in the main chain thereof. Specific examples of the 2,1,3-benzothiadiazole-thiophene type copolymer include those represented by the following general formulae (5) to (8). In the following general formulae (5) to (8), each n independently represents an integer of 1 or more and 1000 or less.

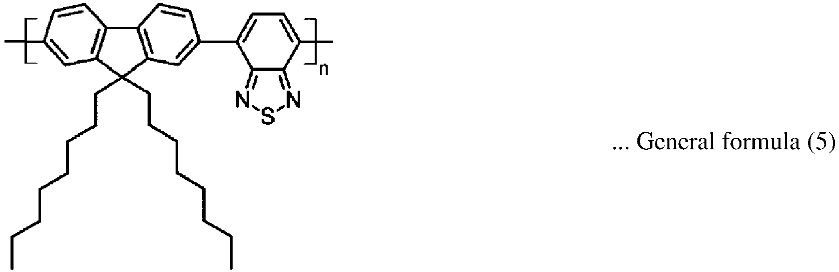

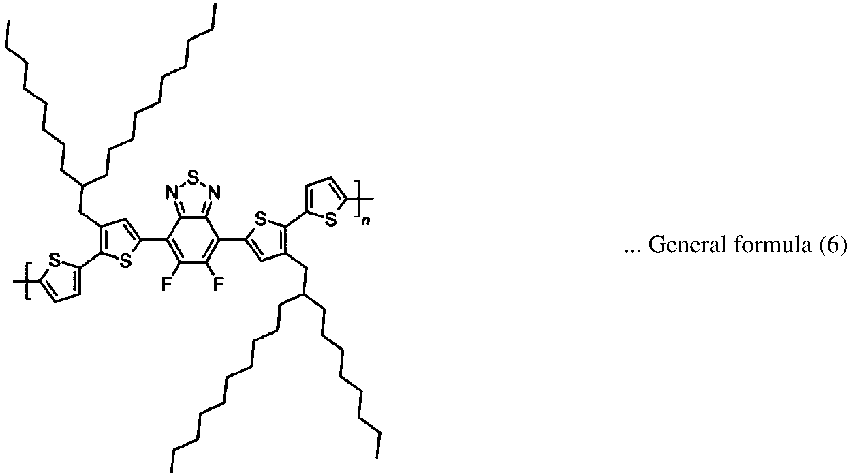

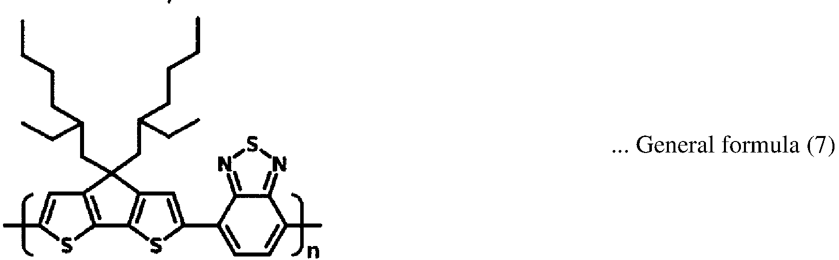

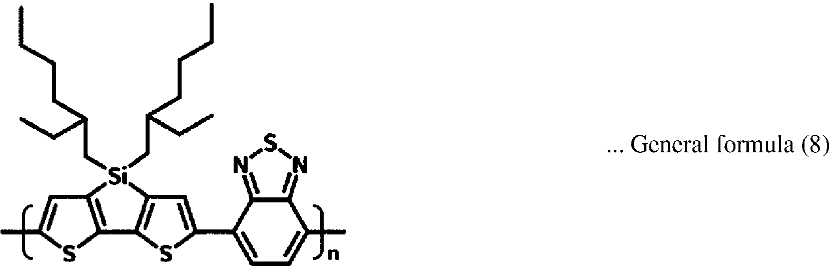

The quinoxaline-thiophene type copolymer represents the conjugated copolymer having a thiophene skeleton and a quinoxaline skeleton in the main chain thereof. Specific examples of the quinoxaline-thiophene type copolymer include those represented by the following general formula (9). In the general formula (9), n represents an integer of 1 or more and 1000 or less.

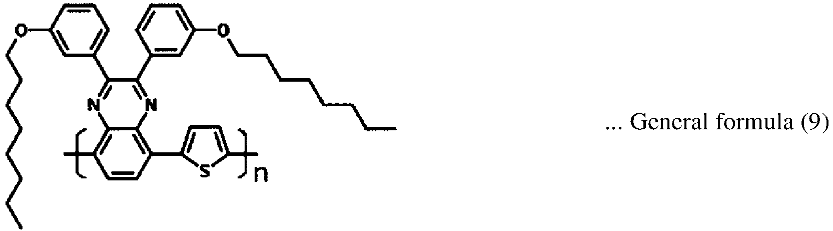

The thiophene-benzodithiophene type copolymer represents the conjugated copolymer having a thiophene skeleton and a benzodithiophene skeleton in the main chain thereof. Specific examples of the thiophene-benzodithiophene type copolymer include those represented by the following general formulae (10) to (13). In the general formulae (10) to (13), each n independently represents an integer of 1 or more and 1000 or less. 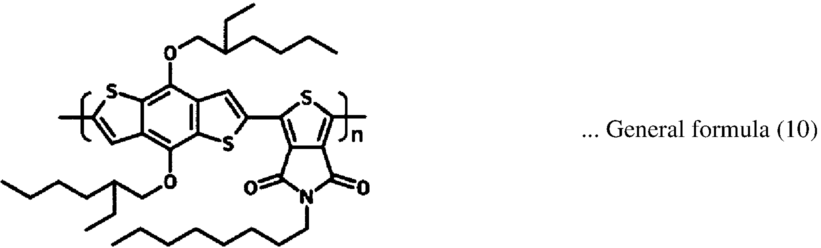 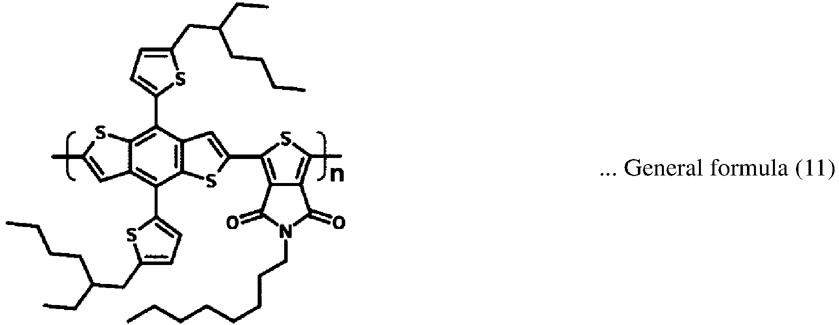 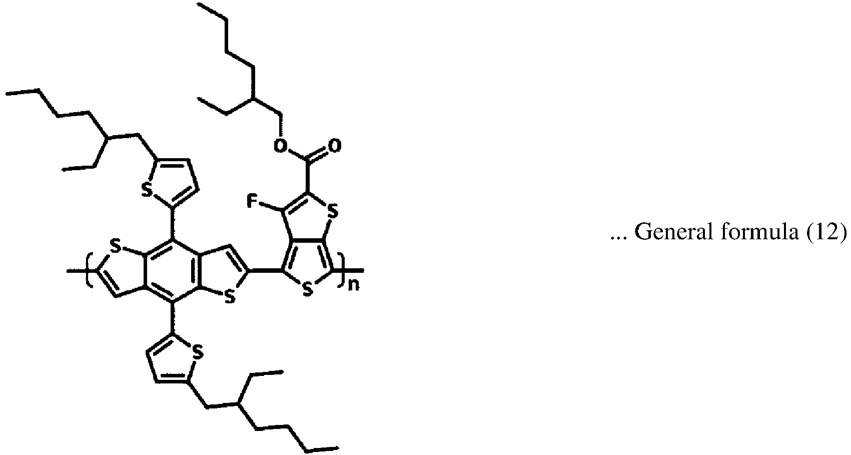 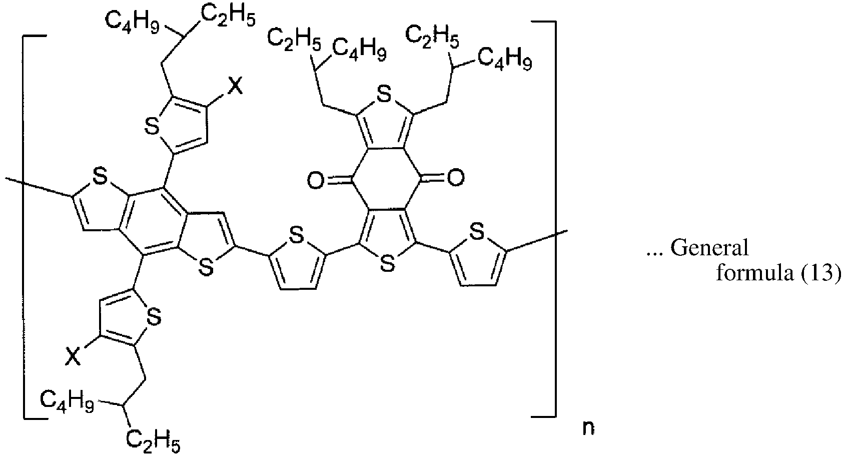 X=H, F, Cl, Br, I

### -Acceptor Organic Material-

The acceptor organic material is preferably a π-electron conjugated compound having the lowest unoccupied molecular orbital (LUMO) level of 3.5 eV or more and 4.5 eV or less.

Illustrative examples of the acceptor organic material include a fullerene or a derivative thereof, a naphthalene tetracarboxylic acid imide derivative, and a perylene tetracarboxylic acid imide derivative. Among these, a fullerene derivative is preferable.

Illustrative examples of the fullerene derivative include C₆₀, methyl phenyl-C₆₁ - lactate (fullerene derivative described as PCBM, [60]PCBM, or PC₆₁BM in published literatures and the like), C₇₀, methyl phenyl-C₇₁-lactate (fullerene derivative described as PCBM, [70]PCBM, or PC₇₁BM in published literatures and the like), and a fulleropyrrolidine type fullerene derivative represented by the following general formula (14).

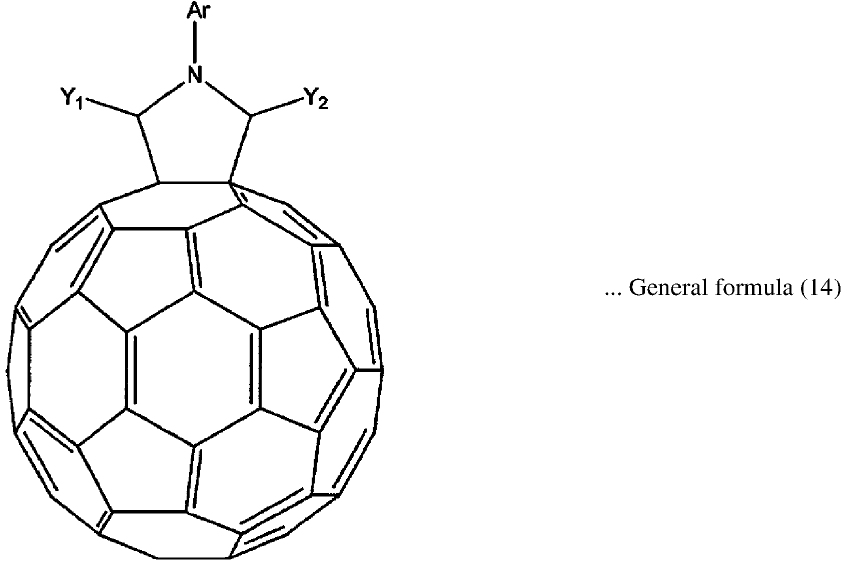

In the general formula (14), Y₁ and Y₂ each independently represent a hydrogen atom, an alkyl group, an alkenyl group, an alkynyl group, an aryl group, or an aralkyl group. However, Y₁ and Y₂ are not hydrogen atoms simultaneously. The alkyl group, the alkenyl group, the alkynyl group, the aryl group, and the aralkyl group described above may or may not have a substituent.

In the general formula (14), Ar represents an aryl group. The aryl group may or may not have a substituent.

### -Average Thickness of Photoelectric Conversion Layer-

The average thickness of the photoelectric conversion layer is preferably 50 nm or more and 400 nm or less, while more preferably 60 nm or more and 250 nm or less. When the average thickness is 50 nm or more, the amount of the carrier due to the light absorption in the photoelectric conversion layer is sufficient. When the average thickness is 400 nm or less, the decrease in the transport efficiency of the carrier generated by light absorption is suppressed.

The average thickness of the photoelectric conversion layer is calculated, for example, by measuring the thickness of the photoelectric conversion layer at the randomly selected 9 points by the following method to determine the average value of these measurements. First, a liquid containing the material that constitutes the photoelectric conversion layer is applied to a base, dried, and then wiped off at an arbitrary point with a solvent. Then, the height of the stage in the wiped portion is measured using DEKTAK manufactured by Bruker Corp. to obtain the measured value as the thickness. The average thickness of the photoelectric conversion layer may also be measured by observing the cross section of the photoelectric conversion device by using a scanning electron microscope (SEM) or a transmission electron microscope (TEM).

-Method for Formation of Bulk Heterojunction in Photoelectric Conversion Layer-The photoelectric conversion layer may be the layer that has a planar junction interface by sequentially stacking each of the above-mentioned organic materials; but, in order to increase the area of the junction interface, it is preferable to form a bulk heterojunction having the structure in which these organic materials are three-dimensionally mixed. The bulk heterojunction is formed, for example, as follows.

When each organic material is a highly soluble material, each organic material is dissolved in a solvent to obtain a solution in which these organic materials are mixed in the molecular state; then, after the mixture is applied, this is dried to remove the solvent. In this case, the agglomeration state of each organic material may be optimized by further conducting a heat treatment.

On the other hand, when using organic materials having low solubility, a liquid in which one organic material is dispersed into the solution having other organic material dissolved therein is prepared; then, after this liquid is applied, drying is carried out to remove the solvent. In this case, the agglomeration state of each organic material may be optimized by further conducting a heat treatment.

### -Method for Forming Photoelectric Conversion Layer-

The method for forming the photoelectric conversion layer includes the process at which the liquid containing the above-mentioned organic materials is applied. Illustrative examples of the application method include a spin coating method, a blade coating method, a slit die coating method, a screen printing method, a bar coating method, a casting method, a printing transfer method, a dip pulling method, an ink-jetting method, a spraying method, and a vacuum vapor deposition method. From these, the method is selected as appropriate in accordance with the characteristics of the photoelectric conversion layer to be formed, such as a thickness control and an orientation control.

For example, when the spin coating method is used, it is preferable to use a solution containing each of the above organic materials at a concentration of 5 mg/mL or more and 40 mg/mL or less. The concentration is the total mass of these organic materials relative to the volume of the solution containing these organic materials. By setting to the above concentration, the photoelectric conversion layer that is homogeneous can be readily prepared.

An annealing treatment may be performed under a reduced pressure or in an inert atmosphere (in a nitrogen or an argon atmosphere) to remove a solvent or a dispersing medium from the liquid containing the organic materials that have been applied. The temperature at the annealing process is preferably 40°C or higher and 300°C or lower, while more preferably 50°C or higher and 150°C or lower. The annealing treatment is desirable because this may lead to the increase in the contact area at the interface between the stacked layers by allowing the materials comprising each layer to penetrate to each other, resulting in the increase in a short-circuit current.

Illustrative examples of the solvent for dissolving or dispersing the organic materials include methanol, ethanol, butanol, toluene, xylene, o-chlorophenol, acetone, ethyl acetate, ethylene glycol, tetrahydrofuran, dichloromethane, chloroform, dichloroethane, chlorobenzene, dichlorobenzene, trichlorobenzene, ortho-dichlorobenzene, chloronaphthalene, dimethylformamide, dimethyl sulfoxide, N-methylpyrrolidone, and γ-butyrolactone. These may be used singly, or in combination of two or more of them. Among these, chlorobenzene, chloroform, and ortho-dichlorobenzene are especially preferable.

The above solvent or dispersing medium may contain various additives. Illustrative examples of the additives include diiodooctane and octane dithiol.

### <Hole Transport Layer>

The "hole transport layer" is the layer that transports a hole generated in the photoelectric conversion layer and inhibits penetration of the electron generated in the photoelectric conversion layer. The hole transport layer may have a structure consisting of one layer or of two or more layers. Hereinafter, as one example thereof, the structure having one layer of the hole transport layer will be described.

It is preferable that the hole transport layer be the layer that contains at least one compound selected from an organic compound and an inorganic compound having the hole transportable property. Illustrative examples of the organic compound having the hole transportable property include a conductive polymer such as PEDOT:PSS (polyethylene dioxythiophene:polystyrenesulfonic acid) and an aromatic amine derivative. Illustrative examples of the inorganic compound having the hole transportable property include molybdenum oxide, tungsten oxide, vanadium oxide, nickel oxide, and copper(I) oxide. Among these compounds having the hole transportable property, molybdenum oxide, tungsten oxide, and vanadium oxide are preferable.

The average thickness of the hole transport layer is preferably 200 nm or less, while more preferably 1 nm or more and 50 nm or less.

Illustrative examples of the method for producing the hole transport layer include the method in which the liquid containing a compound having the hole transportable property, as well as a solvent or a dispersing medium is applied followed by drying this liquid. Illustrative examples of the application method include a spin coating method, a sol-gel method, a slit die coating method, and a sputtering method.

### <Second Electrode>

The "second electrode" is the electrode that collects the holes generated by the photoelectric conversion. When the second electrode is arranged closer to the incidence plane, from a viewpoint to enhance the photoelectric conversion efficiency, it is preferable that the second electrode be high in light permeability, while more preferably transparent. However, when the second electrode is arranged opposite to the incidence plane, this may be low in the light permeability and transparency.

The second electrode may be the same as the first electrode described before; so, the description of this electrode is omitted.

### <Surface Protection Portion>

The "surface protection portion (also called "passivation layer" when layered)" is a member that prevents direct contact between the sealing member and, of the first and the second electrode, the electrode that is arranged in the location farer away from the plane of incident light, and that is arranged between the one electrode and the sealing member. Although the shape of the surface protection portion is not particularly restricted, this is preferably layered. Because the surface protection portion is formed on one electrode (specifically, this portion is formed so as to be adjacent to a surface not facing the photoelectric conversion layer of one electrode), the photoelectric conversion device can be configured such that the adhesive member that constitutes the sealing member does not come into direct contact with the one electrode, so that the problem of delamination caused by transfer of the material constituting the one electrode to the adhesive member is suppressed.

Illustrative examples of the material that constitutes the surface protection portion include metal oxides such as SiOₓ, SiOₓN_{y}, and Al₂O₃, as well as polyethylene, a fluorine-based material, and polymers such as poly-para-xylylene. These may be used singly, or in combination of two or more of them. Among these, metal oxides or fluorine-based materials are preferable.

Illustrative examples of the method for producing the surface protection portion include a vacuum deposition method, a sputtering method, a reactive sputtering method, MBE (molecular beam epitaxy), a plasma CVD method, a laser CVD method, a thermal CVD method, a gas source CVD method, a coating method, a printing method, and a transfer method.

### <Sealing Member>

The "sealing member" is the member that prevents external substances such as water and oxygen from penetrating into the photoelectric conversion device and coming into contact with each of the layers. It is preferable for the sealing member to have, from the one electrode side, an adhesive member that enables the sealing member to be bonded to other members, and a gas barrier member that prevents external substances from penetrating into the photoelectric conversion device in sequence, while it is more preferable for these members to be integrated into a film-type member. The term "in sequence" means that these members may be arranged in the above order as a whole; so, other members or layers, or the like may be inserted between the adhesive member and the gas barrier member. When the sealing member is arranged opposite to the incidence plane, the sealing member is not necessary to have light permeability or transparency. The sealing member is preferably the member that constitutes the outermost portion of the photoelectric conversion device.

The functions required for the gas barrier material are generally expressed in terms of a water vapor permeability, an oxygen permeability, and the like. The water vapor permeability per day in accordance with the JIS K7129 B method is preferably, for example, 10 g/m² or less, although the lower the better. The oxygen permeability per day in accordance with JIS K7126-2 is preferably, for example, 1 cm³/m² • atm or less, although the lower the better.

In the adhesive member, for example, a general material used for sealing of an organic electroluminescence device, an organic transistor, and the like can be used as the material thereof. Specifically, illustrative examples thereof include a pressure-sensitive adhesive resin, a thermosetting resin, a thermoplastic resin, and a photocurable resin. Among these, the pressure-sensitive adhesive resin, which does not require heating at the sealing process, is preferable. Specific examples of the material for the adhesive member include an ethylene-vinyl acetate copolymer resin, a styrene-isobutylene resin, a hydrocarbon-based resin, an epoxy-based resin, a polyester-based resin, an acrylic-based resin, a urethane-based resin, and a silicone-based resin. Variety of adhesive properties can be obtained by chemical modification of a main chain, a branched chain, and a terminal of these resins, as well as by adjusting the molecular weight thereof, and the like.

### <UV-cut Layer>

The "UV-cut layer" is the layer that is arranged closer to the incidence plane and that suppresses deterioration of the photoelectric conversion device due to a UV light. It is preferable that the UV-cut layer be a film-like member that absorbs a UV light. The UV-cut layer is preferably arranged on the base located closer to the incidence plane.

In general, the function required for the UV-cut layer is expressed in terms of light transmittance, and the like. The light transmittance at a wavelength of 370 nm or less is preferably less than 1%, for example. In addition, the light transmittance at a wavelength of 410 nm or less is preferably less than 1%, for example.

### <Gas Barrier Layer>

The "gas barrier layer" is the layer that prevents external substances such as water and oxygen from penetrating into the photoelectric conversion device. The gas barrier layer is preferably a continuous film. The gas barrier layer is arranged preferably adjacent to the base (device base), while more preferably between the other electrode and the base. Note that when the gas barrier layer is arranged adjacent to the base, the gas barrier layer is regarded as one component that constitutes the base (device base) in the present disclosure.

The function required for the gas barrier layer is generally expressed in terms of a water vapor permeability, an oxygen permeability, and the like. The water vapor permeability per day in accordance with the JIS K7129 B method is preferably, for example, 10 g/m² or less, although the lower the better. The oxygen permeability per day in accordance with JIS K7126-2 is preferably, for example, 1 cm³/m² • atm or less, although the lower the better.

Illustrative examples of the material for the gas barrier layer include the material such as SiO₂, SiNₓ, Al₂O₃, SiC, SiCN, SiOC, and SiOAl, as well as a siloxane-based material.

### <Other Layers>

The photoelectric conversion device may further have, as needed, other layers such as an insulating porous layer, a deterioration prevention layer, and a protection layer.

### <Configuration of Photoelectric Conversion Layer>

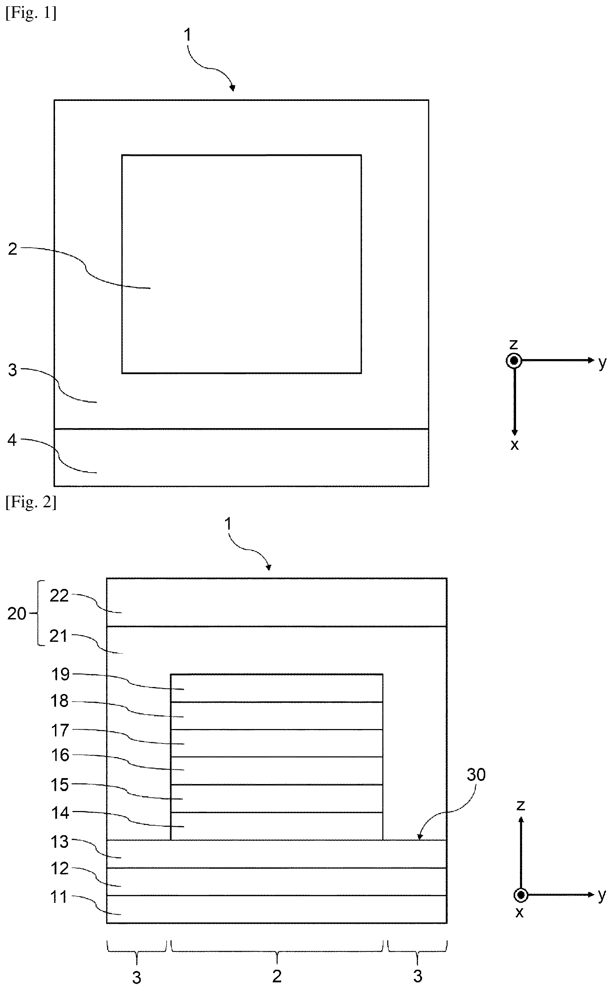

One configuration example of the photoelectric conversion device will be described with referring to Figs. 1 to 2. Fig. 1 is an overlooking schematic view of one example illustrating the photoelectric conversion device. Fig. 2 is a sectional schematic view of one example illustrating the photoelectric conversion device.

As can be seen in the overlooking schematic view in Fig. 1, a photoelectric conversion device 1 has a photoelectric conversion zone 2, which is the zone capable of performing the photoelectric conversion, a sealing zone 3 surrounding the photoelectric conversion zone 2, and other zone 4 where other members such as a terminal are arranged.

As can be seen in the sectional schematic view in Fig. 2, in the photoelectric conversion zone 2, the photoelectric conversion device 1 has a stacked structure consisting of, sequentially from the incidence plane side along the stacking direction z, a UV-cut layer 11, a base 12, a first electrode 13, an electron transport layer 14, an intermediate layer 15, a photoelectric conversion layer 16, a hole transport layer 17, a second electrode 18, a surface protection portion (passivation layer) 19, and a sealing member 20 (hereinafter, this structure is also referred to as "Structure A"). In the sealing zone 3, the photoelectric conversion device 1 has a stacked structure consisting of, sequentially from the incidence plane side along the stacking direction z, the UV-cut layer 11, the base 12, the first electrode 13, and the sealing member 20. At this time, the sealing member 20 has an adhesive member 21 and a gas barrier member 22. The sealing member 20 encapsulates the electron transport layer 14, the intermediate layer 15, the photoelectric conversion layer 16, the hole transport layer 17, the second electrode 18, and the surface protection portion (passivation layer) 19, and is bonded to the surface protection portion (passivation layer) 19 and the adhesion zone 30 in the first electrode 13. Note that, in the photoelectric conversion device 1, the first electrode 13 corresponds to the "other electrode" described above, and the second electrode 18 corresponds to the "one electrode" described above. The photoelectric conversion device 1 may further have a connecting portion or the like to electrically connect in series or in parallel with other photoelectric conversion device. The stacking direction z represents the direction perpendicular to the plane (xy plane) of each layer in the photoelectric conversion device.

The stacking order from the first electrode 13 to the second electrode 18 in the photoelectric conversion zone 2 of the photoelectric conversion device 1 having the structure A is not limited to the order as described above. Specifically, in the photoelectric conversion zone 2, the photoelectric conversion device 1 may have a stacked structure consisting of, sequentially from the incidence plane side along the stacking direction z, the UV-cut layer 11, the base 12, the second electrode 13, the hole transport layer 14, the photoelectric conversion layer 15, the intermediate layer 16, the electron transport layer 17, the first electrode 18, the surface protection portion (passivation layer) 19, and a sealing member 20 (hereinafter, this structure is also referred to as "Structure B"). At this time, the sealing member 20 encapsulates the hole transport layer 14, the photoelectric conversion layer 15, the intermediate layer 16, the electron transport layer 17, the first electrode 18, and the surface protection portion (passivation layer) 19, and is bonded to the surface protection portion (passivation layer) 19 and the adhesion zone 30 in the second electrode 13. Note that, in the photoelectric conversion device 1, the second electrode 13 corresponds to the "other electrode" described above, and the first electrode 18 corresponds to the "one electrode" described above.

In the present disclosure, as illustrated in Figs. 1 and 2, the photoelectric conversion device having the structure A is mainly described as one example, but a person ordinarily skilled in the art can easily understand from this description about the photoelectric conversion device having the structure B.

### <<Photoelectric Conversion Module>>

A "photoelectric conversion module" is the module that has a plurality of the photoelectric conversion devices that are electrically connected. The electrical connection may be made in such a way as to connect the photoelectric conversion devices either in series or in parallel. The photoelectric conversion module may have both a plurality of the photoelectric conversion devices connected in series and a plurality of the photoelectric conversion devices connected in parallel. All the "connections" in the present disclosure shall not be limited to a physical connection, but shall also include an electrical connection.

The photoelectric conversion module has a plurality of the photoelectric conversion devices, a connecting portion that electrically connects the photoelectric conversion devices, and other members as needed. In other words, the photoelectric conversion module has at least a first photoelectric conversion device, a second photoelectric conversion device that is adjacent to the first photoelectric conversion device, a connecting portion that electrically connects the first photoelectric conversion device with the second photoelectric conversion device, and other members as needed. The photoelectric conversion device and the connecting portion may be different only in the functions between them; so, the photoelectric conversion device and the connecting portion may be independent members to each other, or the photoelectric conversion device and the connecting portion may be continuous members or one integrated member. For example, the electrode, which is one member of the photoelectric conversion device, and the connecting portion may be the independent members to each other, or they may be the continuous members or one integrated member.

### <<Method for Producing Photoelectric Conversion Device and Photoelectric Conversion Module>>

Hereinafter, one example of the production method of the photoelectric conversion module will be described, which also means that one example of the production method of the photoelectric conversion device, will be described simultaneously. In the present disclosure, one example of the production method of the photoelectric conversion device having the structure A as illustrated in Fig. 2 will be described. However, from such description, a person ordinarily skilled in the art can easily understand one example of the production method of the photoelectric conversion device having the structure B.

The method for producing the photoelectric conversion module having the photoelectric conversion device includes, for example, a gas barrier layer forming process at which a gas barrier layer is formed on a base, a first electrode forming process at which a first electrode is formed on the base having the gas barrier layer, an electron transport layer forming process at which an electron transport layer is formed on the first electrode, a photoelectric conversion layer forming process at which a photoelectric conversion layer is formed on the electron transport layer, a penetrating portion forming process at which a penetrating portion that penetrates through the electron transport layer and the photoelectric conversion layer is formed, a hole transport layer forming process at which a hole transport layer is formed on the photoelectric conversion layer, and the exposed surfaces of the first electrode, of the electron transport layer, and of the photoelectric conversion layer in the penetrating portion are covered with a material of the hole transport layer, a second electrode forming process at which a second electrode is formed on the hole transport layer, and the penetrating portion is filled by a material of the second electrode to form a penetrating structure, a surface protection portion forming process at which a surface protection portion is formed on the second electrode, an adhesion zone forming process at which an adhesion zone is formed on the first electrode by removing an outer periphery in the stacked materials from the electron transport layer to the surface protection portion, a sealing member forming process at which the sealing member is caused to encapsulate the stacked materials from the electron transport layer to the surface protection portion thereby adhering the surface protection portion with the adhesion zone, and other processes such as a UV-cut layer forming process, as needed.

### <Gas Barrier Layer Forming Process>

The method for producing the photoelectric conversion module having the photoelectric conversion device preferably has a gas barrier layer forming process at which a gas barrier layer is formed on the base. When the base itself has the gas barrier property, it is not necessary to form the gas barrier layer.

### <First Electrode Forming Process>

The method for producing the photoelectric conversion module having the photoelectric conversion device preferably has a first electrode forming process at which a first electrode is formed on the base having the gas barrier layer. When the base does not have the gas barrier layer, the first electrode may be formed on the base.

The method for forming the first electrode has already described in the description about the first electrode.

### <Electron Transport Layer Forming Process>

The method for producing the photoelectric conversion module having the photoelectric conversion device preferably has an electron transport layer forming process at which an electron transport layer is formed on the first electrode.

The method for forming the electron transport layer has already been described in the description of the electron transport layer.

### <Photoelectric Conversion Layer Forming Process>

The method for producing the photoelectric conversion module having the photoelectric conversion device preferably has a photoelectric conversion layer forming process at which a photoelectric conversion layer is formed on the electron transport layer.

The method for forming the photoelectric conversion layer has already been described in the description about the photoelectric conversion layer.

### <Penetrating Portion Forming Process>

The method for producing the photoelectric conversion module having the photoelectric conversion device preferably has a penetrating portion forming process at which a through hole that penetrates through the electron transport layer and the photoelectric conversion layer is formed. In the present disclosure, the penetrating portion represents a vacant hole, and in the case of the photoelectric conversion device having the structure A as illustrated in Fig. 2, this represents the vacant hole that penetrates through the electron transport layer and the photoelectric conversion layer. The shape, the size, and the like of the penetrating portion are not restricted as long as this can electrically connect the photoelectric conversion devices; so, this may be, for example, a line or a circular shape when the photoelectric conversion module is viewed in the plane from the second electrode side, and a rectangular or a square shape when the section of the photoelectric conversion device is observed. Each layer is divided by this penetrating portion to form a plurality of the photoelectric conversion devices. Examples of the method for forming the penetrating portion include a laser deletion and a mechanical scribing.

### <Hole Transport Layer Forming Process>

The method for producing the photoelectric conversion module having the photoelectric conversion device preferably has a hole transport layer forming process at which a hole transport layer is formed on the photoelectric conversion layer, and the exposed surfaces of the first electrode, of the electron transport layer, and of the photoelectric conversion layer in the penetrating portion are covered with a material of the hole transport layer.

The method for forming the hole transport layer has already been described in the description about the hole transport layer.

### <Second Electrode Forming Process>

The method for producing the photoelectric conversion module having the photoelectric conversion device preferably has a second electrode forming process at which a second electrode is formed on the hole transport layer, and the penetrating portion is filled with the material of the second electrode to form a penetrating structure. In the present disclosure, the penetrating structure represents the structural body that fills the interior of the penetrating portion, and in the case of the photoelectric conversion module having the structure A as illustrated in Fig. 2, this represents the structural body formed of the material of the hole transport layer and the material of the second electrode. This penetrating portion functions as the connecting portion between the photoelectric conversion devices.

The method for forming the second electrode has already been described in the description about the second electrode.

### <Surface Protection Portion Forming Process>

The method for producing the photoelectric conversion module having the photoelectric conversion device preferably has a surface protection portion forming process at which a surface protection portion is formed on the second electrode.

The method for forming the surface protection portion has already been described in the description about the surface protection portion.

### <Adhesion Zone Forming Process>

The method for producing the photoelectric conversion module having the photoelectric conversion device preferably has an adhesion zone forming process at which an adhesion zone is formed on the first electrode by removing an outer periphery in the stacked materials from the electron transport layer to the surface protection portion (the electron transport layer, the photoelectric conversion layer, the hole transport layer, the second electrode, and the surface protection portion) thereby exposing the first electrode.

Examples of the method for removing the outer periphery include a laser deletion and a mechanical scribing.

### <Sealing Member Forming Process>

The method for producing the photoelectric conversion module having the photoelectric conversion device may have an sealing member forming process at which the sealing member is caused to encapsulate the stacked materials from the electron transport layer to the surface protection portion (stacked materials of the electron transport layer, the photoelectric conversion layer, the hole transport layer, the second electrode, and the surface protection portion), and the surface protection portion and the adhesion zone are caused to be contacted so as to be adhered to each other.

### <UV-cut Layer Forming Process>

The production method of the photoelectric conversion module having the photoelectric conversion device may, as needed, have a UV-cut layer forming process to form a UV-cut layer closer to the incidence plane.

### <Other Processes>

The production method of the photoelectric conversion module having the photoelectric conversion device may have an insulating porous layer forming process, a deterioration preventive layer forming process, a protection layer forming process, and the like, as needed.

### <Specific Examples of Production Method of Photoelectric Conversion Device and Photoelectric Conversion Module>

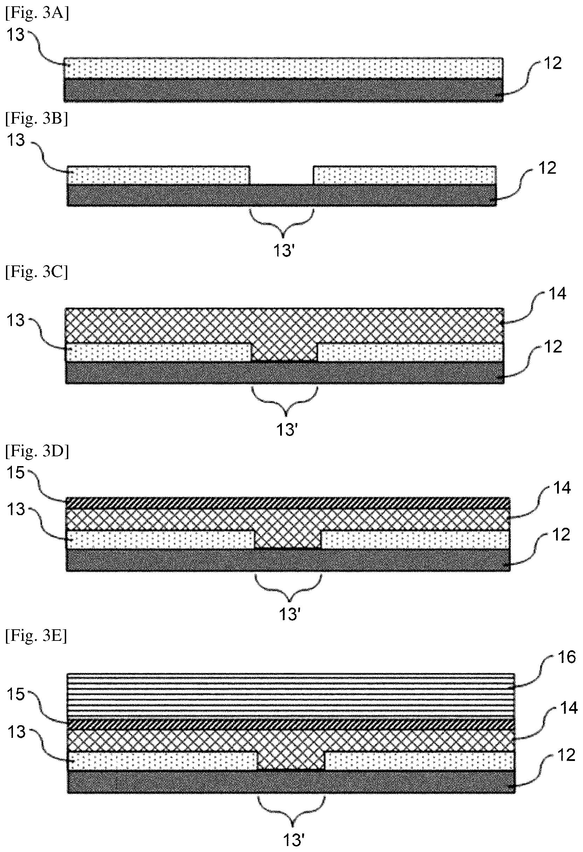

Figs. 3A to 3M are used to describe in detail one example of the method for producing the photoelectric conversion module having the photoelectric conversion device. Figs. 3A to 3M are schematic views of one example illustrating the production method of the photoelectric conversion module.

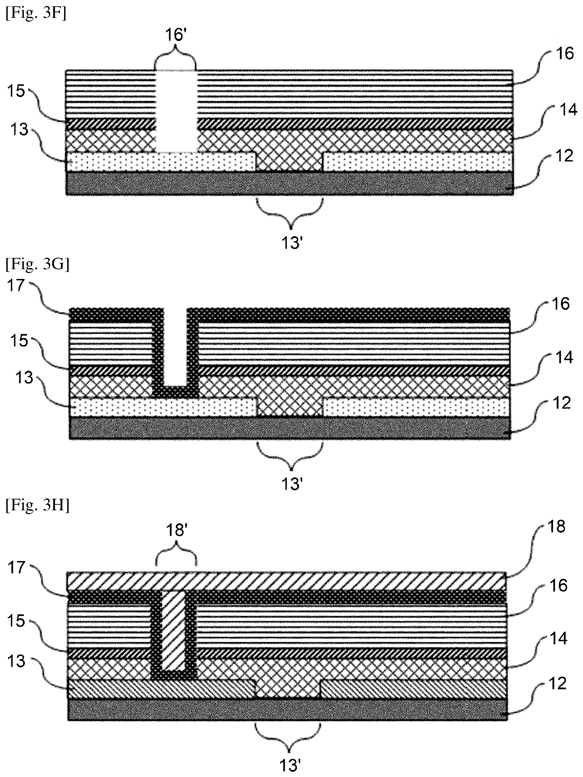

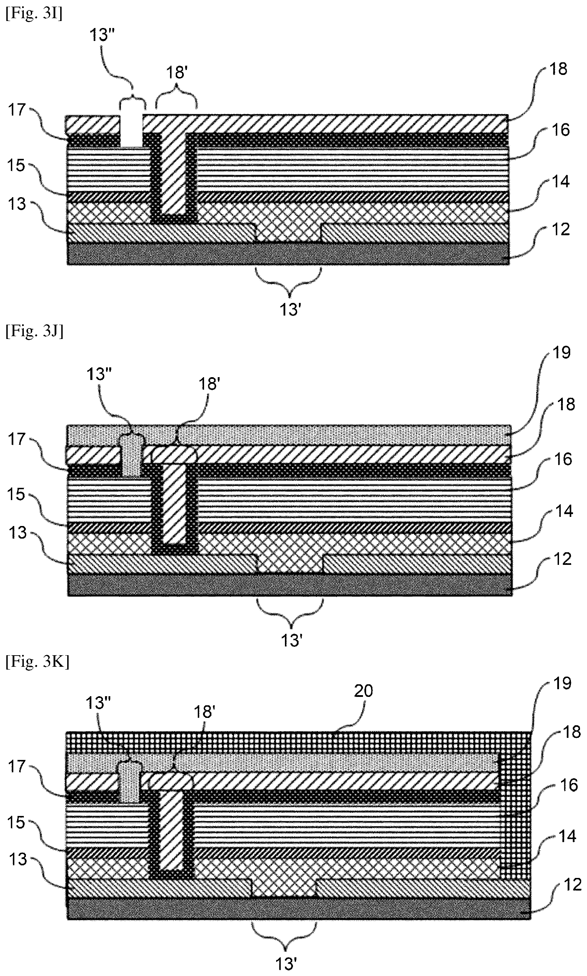

As can be seen in Fig. 3A, first, a first electrode 13 (the other electrode) is formed on a base 12 having a gas barrier property. When forming a plurality of the photoelectric conversion devices on one base 12, as illustrated in Fig. 3B, a part of the formed first electrode 13 is made to disappear to form a first dividing portion 13'. The photoelectric conversion device that is going be formed on the left side of the dividing portion 13' is referred to as a first photoelectric conversion device, and the photoelectric conversion device that is going be formed on the right side of the dividing portion 13' is referred to as a second photoelectric conversion device. Next, as illustrated in Figs. 3C and 3D, an electron transport layer 14 and an intermediate layer 15 are formed on the base 12 and the first electrode 13. Next, a photoelectric conversion layer 16 is formed on the intermediate layer 15 thus formed, as illustrated in Fig. 3E. After forming the photoelectric conversion layer 16, as illustrated in Fig. 3F, predetermined areas of the electron transport layer 14, the intermediate layer 15, and the photoelectric conversion layer 16, these being formed on the first electrode 13, are removed to form a penetrating portion 16'. After forming the penetrating portion 16', a hole transport layer 17 and a second electrode 18 are formed as illustrated in Figs. 3G and 3H. With formation of the hole transport layer 17 and the second electrode 18, a connecting portion 18', which is the structural body made of the material of the hole transport layer and the material of the second electrode, is formed in the penetrating portion 16'. When forming a plurality of the photoelectric conversion devices on one base 12, as illustrated in Fig. 3I, a predetermined area between the second electrode 18 (one electrode) in the first photoelectric conversion device and the second electrode 18 (one electrode) in the second photoelectric conversion device is removed in such a way as to penetrate the second electrode 18 and the hole transport layer 17 to form a second dividing portion 13". Next, as illustrated in Fig. 3J, a surface protection portion 19 is formed on the second electrode 18. At this time, with formation of the surface protection portion 19, a structural body containing the material that constitutes the surface protection portion (assuming that this structural body is also a component of the dividing portion) is formed in the second divided portion 13". This structural body (dividing portion) is continuous with each surface protection portion 19 in the first photoelectric conversion device and the second photoelectric conversion device, as illustrated in Fig. 3J. The structural body described above (division part) is in contact with the side surfaces of the second electrodes 18 (one electrodes) of the first photoelectric conversion device and the second photoelectric conversion device, the side surfaces of the hole transport layers 17 of the first photoelectric conversion device and the second photoelectric conversion device, and the photoelectric conversion layer 16, as illustrated in Fig. 3J. Because the structural body (dividing portion), which has the same material as the material that constitutes the surface protection portion, is in contact with and covers the side surfaces as well as the photoelectric conversion layer, the contact of water or oxygen that penetrates from the outside with each layer of the photoelectric conversion layer and the like can be suppressed; thus, corrosion, deterioration, and the like that occur over time in each layer of the photoelectric conversion layer and the like can be suppressed, thereby enhancing the storage durability thereof. Next, as illustrated in Fig. 3K, the first electrode 13 is exposed by removing the outer periphery of the stacked layers from the electron transport layer 14 to the surface protection portion 19 to form the adhesion zone on the first electrode 13; and furthermore, the stacked layers from the electron transport layer to the surface protection portion are encapsulated by the sealing member 20, and also the surface protection portion and the adhesion zone are adhered by bringing them into contact to each other.

### <<Photoelectric Conversion Module Relating to Organic Thin Film Solar Cell>>

A "photoelectric conversion module" is the module that has a plurality of the photoelectric conversion devices that are electrically connected. The electrical connection may be made in such a way as to connect the photoelectric conversion devices either in series or in parallel. The photoelectric conversion module may have both a plurality of the photoelectric conversion devices connected in series and a plurality of the photoelectric conversion devices connected in parallel. All the "connections" in the present disclosure shall not be limited to a physical connection, but shall also include an electrical connection.

The photoelectric conversion module has a plurality of the photoelectric conversion devices, a connecting portion that electrically connects the photoelectric conversion devices, and other members as needed. In other words, the photoelectric conversion module has at least a first photoelectric conversion device, a second photoelectric conversion device that is adjacent to the first photoelectric conversion device, a connecting portion that electrically connects the first photoelectric conversion device with the second photoelectric conversion device, and other members as needed. The photoelectric conversion device and the connecting portion may be different only in the functions between them; so, the photoelectric conversion device and the connecting portion may be independent members to each other, or the photoelectric conversion device and the connecting portion may be continuous members or one integrated member. For example, the electrode, which is one member of the photoelectric conversion device, and the connecting portion may be the independent members to each other, or they may be the continuous members or one integrated member.

### <<Electronic Device>>

The electronic device has at least the photoelectric conversion device described above (this may also be a photoelectric conversion module having a plurality of the photoelectric conversion devices) and a device that is electrically connected to the said photoelectric conversion device. The device that is electrically connected to the photoelectric conversion device is the device that can act by an electric power or the like generated by photoelectric conversion by the photoelectric conversion device. The electronic device may have a plurality of embodiments depending on the use thereof, including a first embodiment and a second embodiment described below.

The first embodiment is the electronic device having the photoelectric conversion device, the device that is electrically connected to the said photoelectric conversion device, and other devices as needed.

The second embodiment is the electronic device having the photoelectric conversion device, a storage battery that is electrically connected to the said photoelectric conversion device, a device that is electrically connected to the said photoelectric conversion device and to the storage battery, and other devices as needed.

### <<Power Supply Module>>

The power supply module has at least the photoelectric conversion device, a power supply IC (Integrated Circuit) that is electrically connected to the said photoelectric conversion device, and other devices as needed.

### <<Usage>>

The photoelectric conversion device can function as a stand-alone power source, in which the power generated by the photoelectric conversion can be used to cause the device to be operated. Because the photoelectric conversion device can generate an electricity when irradiated with light, there is no need to connect the electronic device to an external power source or to exchange a battery. This enables the electronic device to be operated in a place where there is no power supply facility, to be carried around by wearing it, and to be operated without exchanging a battery in a place where it is difficult to replace it. In addition, when a dry battery is used in an electronic device, the electronic device increases the weight and size thereof, thereby making it difficult to install on a wall or a ceiling or to carry around. However, the photoelectric conversion device is light and thin, so that not only this has high freedom in selection of the installation place thereof but also it is advantageous when it is worn or is carried around.

Accordingly, because the photoelectric conversion device can be used as a stand-alone power source, the electronic device equipped with the photoelectric conversion device can be used for various applications. Illustrative examples of the application of the electronic device mounted with the photoelectric conversion device include: display devices such as an electronic desktop calculator, a wristwatch, a cellular phone, an electronic organizer, and an electronic paper; personal computer accessories such as a personal computer mouse and a personal computer keyboard; various sensing devices such as a temperature/humidity sensor and a human sensor; transmitters such as a beacon and a global positioning system (GPS), an auxiliary light, and a remote controller.

The photoelectric conversion device of the present disclosure can generate an electricity even with a low illuminance. The low illuminance is, for example, an illuminance by lighting or the like in an indoor environment. Specifically, the illuminance in this is 20 lux or more and 1,000 lux or less, which is extremely low as compared to the direct sun light (approximately 100,000 lux). In other words, this can generate a power indoors, even in a dimly lit shadow, thereby making this applicable to a wide range of applications. This is safe as well, because there is no leakage like a dry battery and this cannot be accidentally swallowed like a button battery. Moreover, this can be used as an auxiliary power source to extend the continuous use time of a rechargeable or a dry-cell powered electric appliance. Accordingly, by combining the photoelectric conversion device with a device that acts by an electric power generated by photoelectric conversion by the photoelectric conversion device, an electronic device that is lightweight, easy to use, flexible in an installation place, not requiring replacement, highly safe, and effective in reducing an environmental impact can be obtained. Therefore, the electronic device equipped with the photoelectric conversion device can be used for a variety of applications.

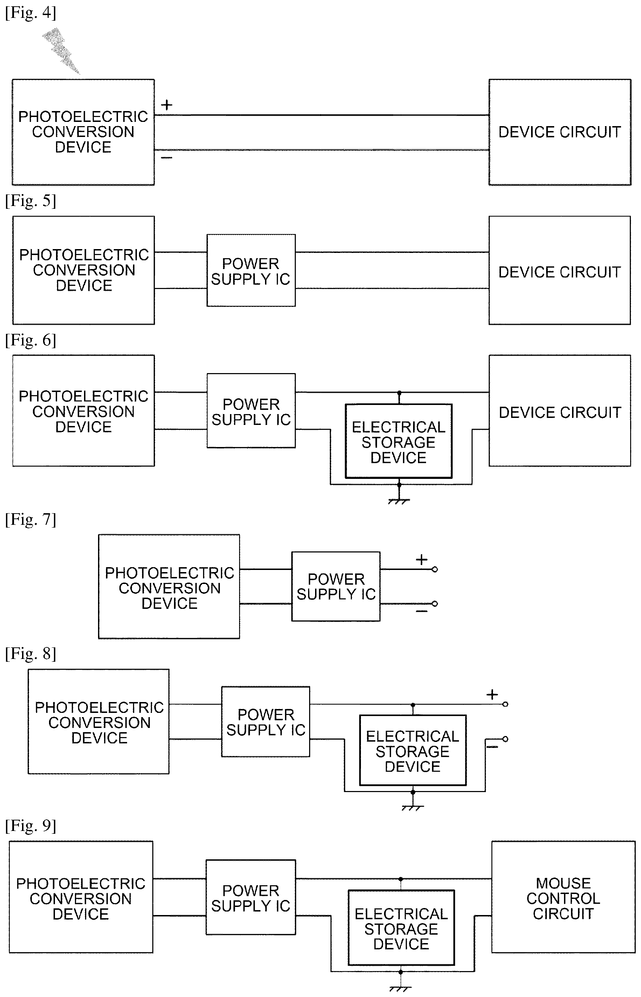

Fig. 4 is a schematic diagram of one example illustrating the basic configuration of the electronic device that combines the photoelectric conversion device with a device circuit that is operated by the power generated by photoelectric conversion by the photoelectric conversion device. When the photoelectric conversion device is irradiated with light, this generates an electricity, from which a power can be taken out thereby enabling to operate the device circuit by this power.

However, because the output of the photoelectric conversion device varies with an ambient illuminance, the electronic device illustrated in Fig. 4 does not always act stably. In this case, in order to supply a stable voltage to the device circuit, it is preferable to incorporate a power supply IC between the photoelectric conversion device and the device circuit, as illustrated in the schematic diagram of one example of the basic configuration of the electronic device in Fig. 5.

The photoelectric conversion device can generate an electricity when exposed to light of a sufficient illuminance; but when the illuminance is not enough to generate an electricity, the intended power cannot be obtained, which is also a drawback of the photoelectric conversion device. In this case, as illustrated in the schematic diagram of one example of the basic configuration of the electronic device in Fig. 6, by installing an electrical storage device such as a capacitor between the power supply IC and the device circuit, a surplus power from the photoelectric conversion device can be charged into the electrical storage device. Accordingly, even when the illuminance is too low or the photoelectric conversion device is not illuminated, the power stored in the electrical storage device can be supplied to the device circuit, so that the device circuit can act stably.

As can be seen above, in the electronic device that combines the photoelectric conversion device with the device circuit, by combining the power supply IC with the electrical storage device, the device can be operated even in an environment without a power supply, and can be driven stably without the need of battery replacement, so that the electronic device equipped with the photoelectric conversion device can be used for various applications.

In addition, the photoelectric conversion device can be used as a power supply module as well. For example, as can be seen in the schematic diagram in Fig. 7 that illustrates one example of the basic configuration of the power supply module, when the photoelectric conversion device is connected to the power supply IC, a direct current power supply module can be constructed that can supply the power generated by photoelectric conversion by the photoelectric conversion device at a constant voltage level with the power supply IC.

Furthermore, as illustrated in the schematic diagram of one example of the basic configuration of the power supply module in Fig. 8, by adding the electrical storage device to the power supply IC, the power generated by the photoelectric conversion device can be charged into the electrical storage device. Accordingly, the power supply module that can supply the power, even when the illuminance is very low or when no light is available to the photoelectric conversion device, can be constructed.

The power supply modules illustrated in Figs. 7 and 8 can be used as the power supply module without replacing batteries as with case of the conventional primary battery. Accordingly, the power supply module having the photoelectric conversion device can be used for various applications.

Hereinafter, specific applications of the electronic device having the photoelectric conversion device and the device operable by an electric power will be described.

### <Application for Personal Computer Mouse>

Fig. 9 is a schematic diagram illustrating one example of the basic configuration of a personal computer mouse (hereinafter this is also referred to as "mouse") as one example of the electronic device. As illustrated in Fig. 9, the mouse has the photoelectric conversion device, a power supply IC, an electrical storage device, and a mouse control circuit. The power for the mouse control circuit is supplied from the connected photoelectric conversion device or the electrical storage device. This allows the electrical storage device to be charged when the mouse is not in use thereby causing the mouse to be operated with this power; thus, the mouse that does not require wiring or battery replacement can be obtained. In addition, because a battery is not necessary, the weight can be reduced so that this is suitably used for the mouse application.

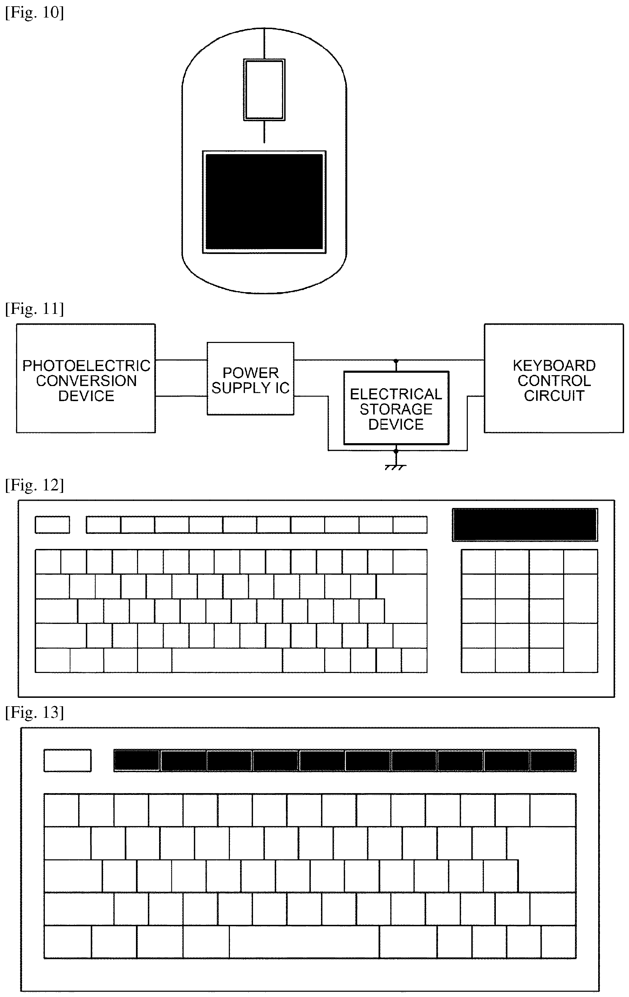

Fig. 10 is a schematic appearance of one example of a personal computer mouse illustrated in Fig. 9. As illustrated in Fig. 10, the photoelectric conversion device, the power supply IC, the electrical storage device, and the mouse control circuit are mounted inside the mouse, in which the top of the photoelectric conversion device is covered by a transparent housing to allow light to reach the photoelectric conversion device. The entire mouse housing can also be molded with a transparent resin. The placement of the photoelectric conversion device is not limited to this; for example, this can be placed in a position where light hits the photoelectric conversion device even when the mouse is covered by a hand.

### <Personal Computer Keyboard Application>

Fig. 11 is a schematic diagram illustrating one example of the basic configuration of a personal computer keyboard (hereinafter this is also referred to as "keyboard") as one example of the electronic device. As illustrate in Fig. 11, the keyboard has the photoelectric conversion device, the power supply IC, the electrical storage device, and a keyboard control circuit. The power for the keyboard control circuit is supplied by the connected photoelectric conversion device or by the electrical storage device. This allows the keyboard to be charged to the electrical storage device when the keyboard is not in use, and the keyboard to be operated with this power, so that the keyboard that does not require wiring or battery replacement can be obtained. In addition, because a battery is not necessary, the weight can be reduced so that this is suitably used for the keyboard application.

Fig. 12 is a schematic appearance of one example illustrating the personal computer keyboard illustrated in Fig. 11. As illustrated in Fig. 12, the photoelectric conversion device, the power supply IC, the electrical storage device, and a keyboard control circuit are mounted inside the keyboard, in which the top of the photoelectric conversion device is covered by a transparent housing to allow light to reach the photoelectric conversion device. The entire keyboard housing can also be molded with a transparent resin. The placement of the photoelectric conversion device is not limited to this. For example, when the keyboard has a small space for the photoelectric conversion device to be incorporated, a small photoelectric conversion device can be embedded in a part of the keys, as illustrated in the schematic appearance of another example of the personal computer keyboard in Fig. 11 of Fig. 13.

### <Sensor Application>

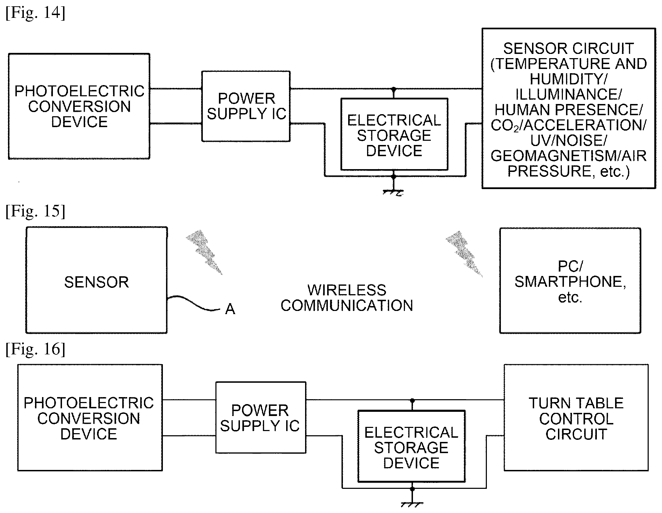

Fig. 14 is a schematic diagram illustrating one example of the basic configuration of a sensor as one example of the electronic device. As illustrated in Fig. 14, the sensor has the photoelectric conversion device, the power supply IC, the electrical storage device, and a sensor circuit. The power for the sensor circuit is supplied by the connected photoelectric conversion device or by the electrical storage device. This allows the sensor to be configured without the need to connect to an external power supply or to replace the battery. Sensing targets of the sensor can include temperature, humidity, illuminance, human presence, CO₂, acceleration, UV, noise, geomagnetism, and air pressure. It is preferable that the sensor periodically sense the measurement target and transmit the acquired data to a personal computer (PC) or a smartphone via a wireless communication, as illustrated in A in Fig. 15.

With the advent of the Internet of Things (IoT) society, sensors are expected to proliferate rapidly. On the other hand, replacing the battery for each of these myriad sensors would be cumbersome, and thus would be impractical. The workability of sensor is also deteriorated when this is placed in the location where it is difficult to replace the battery, such as a ceiling and a wall. Therefore, the sensor that can be empowered by the photoelectric conversion device is of a great advantage. The photoelectric conversion device according to the present disclosure also has the advantages that the output is high even at a low illuminance and has low dependency on the light incident angle, which bring about a high degree of freedom in selection of the installation location thereof.

### <Turntable Application>

Fig. 16 is a schematic diagram illustrating one example of the basic configuration of a turntable as one example of the electronic device. As illustrated in Fig. 16, the turntable has the photoelectric conversion device, the power supply IC, the electrical storage device, and a turntable control circuit. The power for the turntable control circuit is supplied by the connected photoelectric conversion device or by the electrical storage device. This allows the turntable to be configured without the need to connect to an external power supply or to replace the battery. The turntable is used, for example, in a showcase that display merchandises, in which the wiring for the power supply is unattractive. In addition, when the battery is replaced, the displayed items need to be removed with a cumbersome work. Therefore, the turntable that can be empowered by the photoelectric conversion device is of a great advantage.

### Examples

Hereinafter, Examples of the present invention will be described, but the present invention is not limited to these Examples at all.

### (Example 1)

### <Preparation of Photoelectric Conversion Device>

### -Base Having First Electrode-

First, a polyethylene terephthalate (PET) base having a gas barrier layer patterned with an indium-doped tin oxide (ITO) was purchased from Geomatech Co., Ltd.

### -Formation of Electron Transport Layer-

Next, a solution of AZO nanoparticles, i.e., the dispersion liquid containing the metal oxide particles (number-average particle diameter of 12 nm, manufactured by Aldrich Co. LCC), was spin-coated onto the ITO gas barrier PET film (15 Ω/sq.) at 3,000 rpm, and then, heated at 100°C for 10 minutes to arrange the metal oxide particles (AZO particles) having the average thickness of 30 nm on the base.

Also, 0.5 mmmol of zinc acetate dihydrate, 0.5 mmol of 2-ethanolamine, and 20 mL of 2-methoxyethanol were mixed and stirred at room temperature for 1 hour to prepare the solution containing a metal oxide precursor. Next, the resulting solution was spin-coated at 3,000 rpm onto an ITO gas barrier PET film (15 Ω/sq.) on which the AZO particles were arranged, and then, this was heated at 130°C for 10 minutes to form the electron transport layer having an average thickness of 40 nm and containing a metal oxide film (ZnO film) in the space between the metal oxide particles (AZO particles).

When the X-ray photoelectron spectroscopy (XPS) analysis was performed on the formed electron transport layer by the following method, two peaks representing the 1s orbitals of the oxygen atoms were detected, and when the peak area of the peak on the low-energy side of the two peaks was designated by X and the peak area of the peak on the high-energy side among the two peaks was designated by Y, the value calculated by the formula "Y/(X+Y)" was obtained. The calculation result is described in Table 1 below.

For the X-ray photoelectron spectroscopy (XPS) analysis, K-Alpha (Thermo Fisher Scientific Inc.) was used. Peak separation processing was performed using CasaXPS, which is the analysis software attached to the X-ray photoelectron spectrometer. Specifically, the analysis was performed in the binding energy range of the elemental spectra of interest, using the peak separation and fitting functions prescribed by the software. The separation conditions are not particularly restricted as long as the method can perform the analysis with good reproducibility. The peak abundance for each bonding state was calculated by calculating the peak area for each of the spectra in which the peaks were separated for the element of interest. The conditions for calculating the peak abundance are not particularly restricted as long as the analysis can be done with good reproducibility.

### -Formation of Photoelectric Conversion Layer-

Next, 15 mg of the example compound 1 described below (number-average molecular weight (Mn) of 1,554, and the highest occupied molecular orbital (HOMO) level of 5.14 eV) and 10 mg of the example compound 3 described below were dissolved in 1 mL of chloroform to make the photoelectric conversion layer coating liquid A.

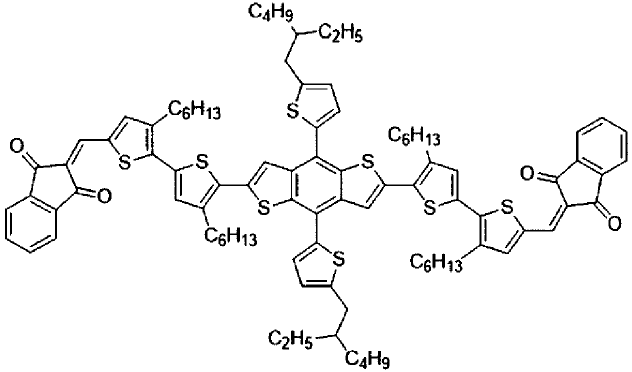

### ... Example compound 1

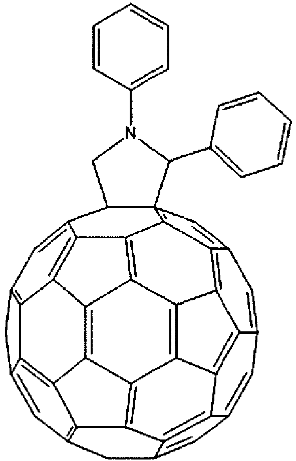

### ... Example compound 3

Next, the photoelectric conversion layer coating liquid A was spin-coated onto the electron transport layer at 600 rpm to form the photoelectric conversion layer having the average thickness of 300 nm.

### -Formation of Hole Transport Layer and Second Electrode-

Next, a hole transport layer material composed of molybdenum oxide (manufactured by Japan Pure Chemical Co., Ltd.) having the average thickness of 20 nm and a second electrode material composed of silver having the average thickness of 100 nm were sequentially applied by vacuum vapor deposition onto the photoelectric conversion layer to form the hole transport layer and the second electrode.

### -Evaluation of Aging Characteristics of Solar Cells-

First, the current-voltage characteristic of the produced photoelectric conversion device was measured under irradiation of a white LED (0.07 mW/cm² and illuminance of 200 lx). The initial (at the start of light irradiation) photoelectric conversion efficiency was calculated from the obtained current-voltage curve. The measurement was done using a white LED irradiation with a bulb-type LED lamp (LDA11N-G/100W, manufacture by Toshiba Lighting and Technology Corp.) and an evaluation instrument (source meter) of KETSIGHT B2902A. The output of the LED light source was measured using a spectrometer C-7000, manufactured by Sekonic Co.

Next, the fabricated photoelectric conversion device was allowed to be left under quasi-sunlight irradiation (luminance of 100,000 lx) for 500 hours at normal temperature and humidity, and then the current-voltage curve was measured in the same way as before; then, from the obtained current-voltage curve, the photoelectric conversion efficiency after long-term light irradiation was calculated.

Then, the ratio of the photoelectric conversion efficiency after long-term light irradiation to the initial photoelectric conversion efficiency was calculated. The calculation result is described in Table 1 below.

### (Example 2)

### <Preparation of Photoelectric Conversion Device>

In the preparation of the electron transport layer in Example 1, the photoelectric conversion device was prepared in the same way as in Example 1 except that the following method was used.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Formation of Electron Transport Layer-

The mixed liquid obtained by mixing the dispersion liquid containing the metal oxide particles used in Example 1 and the solution containing the metal oxide precursor in a mass ratio of 1:1 was spin-coated onto an ITO gas barrier PET film (15 Ω/sq.) at 3,000 rpm; and then, this was heated at 130°C for 10 minutes to form an electron transport layer having an average thickness of 40 nm and containing a metal oxide film (ZnO film) in the space between the metal oxide particles (zinc oxide particles).

### (Example 3)

### <Preparation of Photoelectric Conversion Device>

In the preparation of the photoelectric conversion device in Example 2, the photoelectric conversion device was prepared in the same way as in Example 2 except that the photoelectric conversion layer coating liquid A was changed to the photoelectric conversion layer coating liquid B described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid B-

The example compound 1 (15 mg), 5 mg of P3HT (manufactured by Osilla Ltd., the highest occupied orbital (HOMO) level of 5.2 eV), and 10 mg of the example compound 3 were dissolved in 1 mL of chloroform to make the photoelectric conversion layer coating liquid B.

### (Example 4)

### <Preparation of Photoelectric Conversion Device>

In the preparation of the photoelectric conversion device in Example 3, the photoelectric conversion device was prepared in the same way as in Example 3 except that the intermediate layer described below was formed after formation of the electron transport layer and before formation of the electron transport layer.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Formation of Intermediate Layer-

Next, dimethylaminobenzoic acid (DMABA, manufactured by Tokyo Chemical Industry Co., Ltd.) was dissolved in ethanol to prepare a 1 mg/ml solution, which was then spin-coated onto the electron transport layer at 3,000 rpm to form the intermediate layer having the average thickness of less than 10 nm.

### (Example 5)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid C described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid C-

The example compound 1 (15 mg), 5 mg of P3HT (manufactured by Osilla Ltd., the highest occupied orbital (HOMO) level of 5.2 eV), and 10 mg of PC61BM (manufactured by Frontier Carbon Corp.) were dissolved in 1 mL of chloroform to make the photoelectric conversion layer coating liquid C.

### (Example 6)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid D described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid D-

The example compound 4 described below (15 mg)(number-average molecular weight (Mn) of 1,463 and the highest occupied molecular orbital (HOMO) level of 5.27 eV), 5 mg of P3HT (manufactured by Osilla Ltd., the highest occupied orbital (HOMO) level of 5.2 eV), and 10 mg of PC61BM (manufactured by Frontier Carbon Corp.) were dissolved in 1 mL of chloroform to make the photoelectric conversion layer coating liquid D.

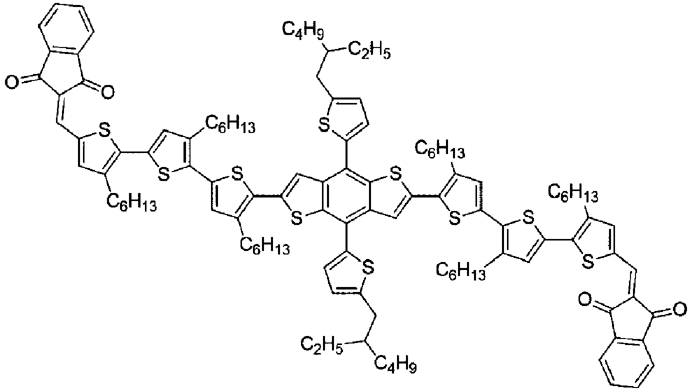

### ... Example compound 4

### (Example 7)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid E described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid E-

The example compound 5 described below (15 mg) (number-average molecular weight (Mn) of 1,886 and the highest occupied molecular orbital (HOMO) level of 5.00 eV), 5 mg of P3HT (manufactured by Osilla Ltd., the highest occupied orbital (HOMO) level of 5.2 eV), and 10 mg of PC61BM (manufactured by Frontier Carbon Corp.) were dissolved in 1 mL of chloroform to make the photoelectric conversion layer coating liquid E.

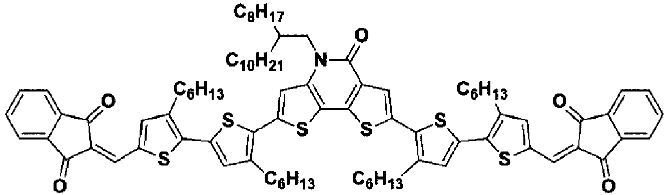

### ... Example compound 5

### (Example 8)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid F described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below. In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid F-

The example compound 1 (15 mg), 5 mg of PTB7 (manufactured by Osilla Ltd., the highest occupied orbital (HOMO) level of 5.15 eV), and 10 mg of PC61BM (manufactured by Frontier Carbon Corp.) were dissolved in 1 mL of chloroform to make the photoelectric conversion layer coating liquid F.

### (Example 9)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid G described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid G-

The example compound 1 (15 mg), 5 mg of PBDB-T (manufactured by Osilla Ltd., the highest occupied orbital (HOMO) level of 5.33 eV), and 10 mg of PC61BM (manufactured by Frontier Carbon Corp.) were dissolved in 1 mL of chloroform to make the photoelectric conversion layer coating liquid G.

### (Example 10)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid H described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below. In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid H-

The example compound 1 (15 mg), 5 mg of PBDB-T-2F (manufactured by Osilla Ltd., the highest occupied orbital (HOMO) level of 5.33 eV), and 10 mg of PC61BM (manufactured by Frontier Carbon Corp.) were dissolved in 1 mL of chloroform to make the photoelectric conversion layer coating liquid H.

### (Example 11)

### <Preparation of Photoelectric Conversion Device>

In the formation of the electron transport layer in Example 4, the photoelectric conversion device was prepared in the same way as in Example 4 except that the following method was used.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Formation of Electron Transport Layer-

A mixed liquid obtained by mixing the ZnO nanoparticle solution (number-average particle diameter of 12 nm, manufacture by Aldrich Co. LCC), which is the dispersion liquid containing the metal oxide particles, and the solution containing the metal oxide precursor used in Example 1 in a mass ratio of 1:1 was spin-coated onto an ITO gas barrier PET film (15 Ω/sq.) at 3,000 rpm; then, this was heated at 130°C for 10 minutes to form an electron transport layer having an average thickness of 40 nm and containing a metal oxide film (ZnO film) in the space between the metal oxide particles (ZnO particles).

### (Example 12)

### <Preparation of Photoelectric Conversion Device>

In the formation of the electron transport layer in Example 4, the photoelectric conversion device was prepared in the same way as in Example 4 except that the following method was used.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Formation of Electron Transport Layer-

A mixed liquid of the SnO₂ nanoparticle solution (number-average particle diameter of 12 to 20 nm, manufactured by Alfa Aesar Inc.), which is the dispersion liquid containing the metal oxide particles, and the solution containing the metal oxide precursor used in Example 1 in a mass ratio of 1:1 was spin-coated onto an ITO gas barrier PET film (15 Ω/sq.) at 3,000 rpm; then, this was heated at 130°C for 10 minutes to form an electron transport layer having an average thickness of 40 nm and containing a metal oxide film (ZnO film) in the space between the metal oxide particles (SnO₂ particles).

### (Example 13)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid I described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid I-

The example compound 1 (12 mg), 3 mg of PBDB-T (manufactured by Osilla Ltd., the highest occupied orbital (HOMO) level of 5.33 eV), and 10 mg of PC61BM (manufactured by Frontier Carbon Corp.) were dissolved in 1 mL of chloroform to make the photoelectric conversion layer coating liquid I.

### (Example 14)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid J described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid J-

The example compound 1 (10 mg), 5 mg of PBDB-T (manufactured by Osilla Ltd., the highest occupied orbital (HOMO) level of 5.33 eV), and 10 mg of PC61BM (manufactured by Frontier Carbon Corp.) were dissolved in 1 mL of chloroform to make the photoelectric conversion layer coating liquid J.

### (Example 15)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid K described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid K-

The example compound 1 (7.5 mg), 7.5 mg of PBDB-T (manufactured by Osilla Ltd., the highest occupied orbital (HOMO) level of 5.33 eV), and 10 mg of PC61BM (manufactured by Frontier Carbon Corp.) were dissolved in 1 mL of chloroform to make the photoelectric conversion layer coating liquid K.

### (Example 16)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid L described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid L-

The example compound 1 (5 mg), 10 mg of PBDB-T (manufactured by Osilla Ltd., the highest occupied orbital (HOMO) level of 5.33 eV), and 10 mg of PC61BM (manufactured by Frontier Carbon Corp.) were dissolved in 1 mL of chloroform to make the photoelectric conversion layer coating liquid L.

### (Example 17)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid M described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid M-

The example compound 1 (6.7 mg), 3.3 mg of PBDB-T (manufactured by Osilla Ltd., the highest occupied orbital (HOMO) level of 5.33 eV), and 10 mg of PC61BM (manufactured by Frontier Carbon Corp.) were dissolve in 1 mL of chloroform to make the photoelectric conversion layer coating liquid M.

### (Example 18)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid N described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid N-

The example compound 1 (6.7 mg), 3.3 mg of PBDB-T (manufactured by Osilla Ltd., the highest occupied orbital (HOMO) level of 5.33 eV), and 15 mg of PC61BM (manufactured by Frontier Carbon Corp.) were dissolved in 1 mL of chloroform to make the photoelectric conversion layer coating liquid N.

### (Example 19)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid O described below.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid O-

The example compound 1 (6.7 mg), 3.3 mg of PBDB-T (manufactured by Osilla Ltd., the highest occupied orbital (HOMO) level of 5.33 eV), and 20 mg of PC61BM (manufactured by Frontier Carbon Corp.) were dissolved in 1 mL of chloroform to make the photoelectric conversion layer coating liquid O.

### (Example 20)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid P described below, and that the average thickness of the photoelectric conversion layer was changed to 150 nm.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid P-

The example compound 1 (6.7 mg), 3.3 mg of PBDB-T (manufactured by Osilla Ltd., the highest occupied orbital (HOMO) level of 5.33 eV), and 20 mg of PC61BM (manufactured by Frontier Carbon Corp.) were dissolved in 1 mL of chloroform to make the photoelectric conversion layer coating liquid P.

### (Example 21)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid Q described below, and that the photoelectric conversion layer coating liquid Q was spin-coated at 500 rpm, and that the average thickness of the photoelectric conversion layer was changed to 500 nm.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid Q-

The example compound 1 (6.7 mg), 3.3 mg of PBDB-T (manufactured by Osilla Ltd., the highest occupied orbital (HOMO) level of 5.33 eV), and 20 mg of PC61BM (manufactured by Frontier Carbon Corp.) were dissolved in 1 mL of chloroform to make the photoelectric conversion layer coating liquid Q.

### (Example 22)

### <Preparation of Photoelectric Conversion Device>

In the preparation of the photoelectric conversion device in Example 4, the photoelectric conversion device was prepared in the same way as in Example 4 except that the photoelectric conversion layer coating liquid B was changed to the photoelectric conversion layer coating liquid R described below, and that the photoelectric conversion layer coating liquid R was spin-coated at 400 rpm, and that the average thickness of the photoelectric conversion layer was changed to 800 nm.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid R-

The example compound 1 (6.7 mg), 3.3 mg of PBDB-T (manufactured by Osilla Ltd., the highest occupied orbital (HOMO) level of 5.33 eV), and 20 mg of PC61BM (manufactured by Frontier Carbon Corp.) were dissolved in 1 mL of chloroform to make the photoelectric conversion layer coating liquid R.

### (Example 23)

### <Preparation of Photoelectric Conversion Device>

In the preparation of the photoelectric conversion device in Example 22, the photoelectric conversion device was prepared in the same way as in Example 22 except that the photoelectric conversion layer coating liquid R was changed to the photoelectric conversion layer coating liquid S described below, and that the photoelectric conversion layer coating liquid S was spin-coated at 600 rpm, and that the average thickness of the photoelectric conversion layer was changed to 450 nm.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid S-

The example compound 1 (8.0 mg), 2.0 mg of PBDB-T (manufactured by Osilla Ltd., the highest occupied orbital (HOMO) level of 5.33 eV), and 20 mg of PC61BM (manufactured by Frontier Carbon Corp.) were dissolved in 1 mL of chloroform to make the photoelectric conversion layer coating liquid S.

### (Example 24)

### <Preparation of Photoelectric Conversion Device>

In the preparation of the photoelectric conversion device in Example 22, the photoelectric conversion device was prepared in the same way as in Example 22 except that the photoelectric conversion layer coating liquid R was changed to the photoelectric conversion layer coating liquid T described below, and that the photoelectric conversion layer coating liquid T was spin-coated at 600 rpm, and that the average thickness of the photoelectric conversion layer was changed to 450 nm.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid T-

The example compound 1 (9.0 mg), 1.0 mg of PBDB-T (manufactured by Osilla Ltd., the highest occupied orbital (HOMO) level of 5.33 eV), and 20 mg of PC61BM (manufactured by Frontier Carbon Corp.) were dissolved in 1 mL of chloroform to make the photoelectric conversion layer coating liquid T.

### (Example 25)

### <Preparation of Photoelectric Conversion Device>

In the preparation of the photoelectric conversion device in Example 22, the photoelectric conversion device was prepared in the same way as in Example 22 except that the photoelectric conversion layer coating liquid R was changed to the photoelectric conversion layer coating liquid U described below, and that the photoelectric conversion layer coating liquid U was spin-coated at 600 rpm, and that the average thickness of the photoelectric conversion layer was changed to 450 nm.

In the same way as in Example 1, the X-ray photoelectron spectroscopy (XPS) analysis was performed on the formed electron transport layer to obtain the value calculated by the formula "Y/(X+Y)". The calculation result is described in Table 1 below. In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid U-

The example compound 1 (8.0 mg), 2.0 mg of PBDB-T (manufactured by Osilla Ltd., the highest occupied orbital (HOMO) level of 5.33 eV), and 15 mg of PC61BM (manufactured by Frontier Carbon Corp.) were dissolved in 1 mL of chloroform to make the photoelectric conversion layer coating liquid U.

### (Example 26)

### <Preparation of Photoelectric Conversion Device>

In the preparation of the photoelectric conversion device in Example 22, the photoelectric conversion device was prepared in the same way as in Example 22 except that the photoelectric conversion layer coating liquid R was changed to the photoelectric conversion layer coating liquid V described below and that the photoelectric conversion layer coating liquid V was spin-coated at 600 rpm, and that the average thickness of the photoelectric conversion layer was changed to 450 nm.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Photoelectric Conversion Layer Coating Liquid V-

The example compound 1 (9.0 mg), 1.0 mg of PBDB-T (manufactured by Osilla Ltd., the highest occupied orbital (HOMO) level of 5.33 eV), and 15 mg of PC61BM (manufactured by Frontier Carbon Corp.) were dissolved in 1 mL of chloroform to make photoelectric conversion layer coating liquid V.

### (Comparative Examples 1, 3 to 10, and 13 to 22)

### <Preparation of Photoelectric Conversion Device>

Photoelectric conversion devices were fabricated in the same way as in Examples 1, 3 to 10, and 13 to 22, respectively, except that the following method was used in the formation of the electron transport layer in Examples 1, 3 to 10, and 13 to 22. In the same way as in Example 1, the X-ray photoelectron spectroscopy (XPS) analysis was performed on the formed electron transport layer to obtain the value calculated by the formula "Y/(X+Y)". The calculation result is described in Table 1 below. In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

### -Formation of Electron Transport Layer-

The solution of AZO nanoparticles (number-average particle diameter of 12 nm, manufactured by Aldrich Co. LCC), which is the dispersion liquid containing the metal oxide particles, was spin-coated onto the ITO gas barrier PET film (15 Ω/sq.) at 3,000 rpm, and then, heated at 100°C for 10 minutes to form the electron transport layer having the average thickness of 30 nm and containing the metal oxide particles (AZO particles).

### (Comparative Example 22')

### <Preparation of Photoelectric Conversion Device>

In the preparation of the photoelectric conversion device in Example 22, the photoelectric conversion device was prepared in the same way as in Example 22 except that the heating temperature at the time of forming the electron transport layer was changed to 200°C.

In the same way as in Example 1, the X-ray photoelectron spectroscopy (XPS) analysis was performed on the formed electron transport layer to obtain the value calculated by the formula "Y/(X+Y)". The calculation result is described in Table 1 below.

In the same way as in Example 1, the evaluation of the aging characteristics of the solar cell was conducted, and the ratio of the photoelectric conversion efficiency after long-term light irradiation to the initial photoelectric conversion efficiency was calculated. The calculation result is described in Table 1 below.

**Table 1**

| | Aging characteristics of solar cell (1000 klx, 500 hours) | Y/(X+Y) |
|---|---|---|
| Example 1 | 50% | 0.62 |
| Example 2 | 51% | 0.51 |
| Example 3 | 53% | 0.68 |
| Example 4 | 56% | 0.62 |
| Example 5 | 57% | 0.69 |
| Example 6 | 52% | 0.60 |
| Example 7 | 54% | 0.62 |
| Example 8 | 63% | 0.55 |
| Example 9 | 71% | 0.62 |
| Example 10 | 75% | 0.53 |
| Example 11 | 74% | 0.64 |
| Example 12 | 78% | 0.56 |
| Example 13 | 74% | 0.58 |
| Example 14 | 73% | 0.50 |
| Example 15 | 76% | 0.67 |
| Example 16 | 71% | 0.62 |
| Example 17 | 73% | 0.56 |
| Example 18 | 80% | 0.51 |
| Example 19 | 74% | 0.63 |
| Example 20 | 78% | 0.66 |
| Example 21 | 70% | 0.59 |
| Example 22 | 65% | 0.66 |
| Example 23 | 78% | 0.56 |
| Example 24 | 81% | 0.58 |
| Example 25 | 78% | 0.67 |
| Example 26 | 79% | 0.54 |
| Comparative Example 1 | 25% | 0.36 |
| Comparative Example 3 | 23% | 0.43 |
| Comparative Example 4 | 31% | 0.40 |
| Comparative Example 5 | 32% | 0.34 |
| Comparative Example 6 | 24% | 0.38 |
| Comparative Example 7 | 23% | 0.41 |
| Comparative Example 8 | 33% | 0.34 |
| Comparative Example 9 | 33% | 0.43 |
| Comparative Example 10 | 35% | 0.33 |
| Comparative Example 13 | 36% | 0.35 |
| Comparative Example 14 | 38% | 0.38 |
| Comparative Example 15 | 31% | 0.39 |
| Comparative Example 16 | 41% | 0.31 |
| Comparative Example 17 | 45% | 0.44 |
| Comparative Example 18 | 47% | 0.42 |
| Comparative Example 19 | 41% | 0.32 |
| Comparative Example 20 | 46% | 0.38 |
| Comparative Example 21 | 40% | 0.40 |
| Comparative Example 22 | 31% | 0.38 |
| Comparative Example 22' | 40% | 0.32 |

### Reference Signs List

1 Photoelectric conversion device
2 Photoelectric conversion zone
3 Sealing zone
4 Other members
11 UV-cut layer
12 Base
13 First electrode
14 Electron transport layer
15 Intermediate layer
16 Photoelectric conversion layer
17 Hole transport layer
18 Second electrode
19 Surface protection portion
20 Sealing member
21 Adhesive member
22 Gas barrier member
30 Adhesion zone

### Citation List

### Patent Literature

PTL 1: Japanese Patent Application Laid-open No. 2014-220333

### Non Patent Literature

NPL 1: Applied Physics Letters 108, 253301 (2016)
NPL 2: Japanese Journal of Applied Physics 54, 071602 (2015)

## Claims

1. A photoelectric conversion device (1) comprising:
a photoelectric conversion layer (16), and
an electron transport layer (14), wherein
the electron transport layer (14) includes metal oxide particles, and
in response to performing an X-ray photoelectron spectroscopy (XPS) analysis on the electron transport layer, two peaks representing 1s orbitals of oxygen atoms are detected, and a formula Y/(X+Y)≥0.5 is satisfied, where a peak area of a peak on a low-energy side among the two peaks is X and a peak area of a peak on a high-energy side among the two peaks is Y.

2. The photoelectric conversion device according to claim 1, wherein a number-average particle diameter of the metal oxide particles is 10 nm or more and 50 nm or less.

3. The photoelectric conversion device according to claim 1 or 2, wherein the metal oxide particles comprise at least one selected from a group consisting of zinc oxide, titanium oxide, and tin oxide as a constituent material.

4. The photoelectric conversion device according to claim 1 or 2, wherein the metal oxide particles comprise zinc oxide as a constituent material.

5. The photoelectric conversion device according to any one of claims 1 to 4, wherein the electron transport layer further comprises a metal oxide film arranged between the metal oxide particles.

6. The photoelectric conversion device according to claim 5, wherein the metal oxide film comprises at least one selected from a group consisting of zinc oxide, titanium oxide, and tin oxide as a constituent material.

7. The photoelectric conversion device according to claim 5, wherein the metal oxide film comprises zinc oxide as a constituent material.

8. The photoelectric conversion device according to any one of claims 1 to 7, wherein a first electrode (13), the electron transport layer, the photoelectric conversion layer, a hole transport layer, and a second electrode (18) are included in sequence.

9. The photoelectric conversion device according to claim 8, wherein the first electrode, the electron transport layer, an intermediate layer, layer (15), the photoelectric conversion layer, the hole transport layer, and the second electrode are included in sequence.

10. The photoelectric conversion device according to any one of claims 1 to 9, wherein the photoelectric conversion layer contains an organic material having a highest occupied molecular orbital (HOMO) level of 5.1 eV or more and 5.5 eV or less and a number-average molecular weight (Mn) of 10,000 or less, the HOMO level is measured via photoelectron yield spectroscopy.

11. An electronic device comprising:
the photoelectric conversion device according to any one of claims 1 to 10; and
a device electrically connected to the photoelectric conversion device.

12. An electronic device comprising:
the photoelectric conversion device according to any one of claims 1 to 10;
a storage battery electrically connected to the photoelectric conversion device; and
a device electrically connected to the photoelectric conversion device and to the storage battery.

13. A power supply module comprising:
the photoelectric conversion device according to any one of claims 1 to 10; and
a power supply IC electrically connected to the photoelectric conversion device.

14. A method for producing a photoelectric conversion device that comprises an electron transport layer (14), the electron transport layer comprising metal oxide particles, the method comprising:
applying a dispersion liquid including the metal oxide particles to arrange the metal oxide particles; and
applying a solution including a metal oxide precursor that is a precursor of a metal oxide, to the arranged metal oxide particles, and changing the metal oxide precursor to the metal oxide by an external stimulation.

15. A method for producing a photoelectric conversion device that comprises an electron transport layer (14), the electron transport layer comprising metal oxide particles, the method comprising:
applying a mixed liquid containing the metal oxide particles and a metal oxide precursor that is a precursor of a metal oxide, to arrange the metal oxide particles and further changing the metal oxide precursor to the metal oxide by an external stimulation.

## Patentansprüche

1. Photoelektrische Umwandlungsvorrichtung (1), umfassend:
eine photoelektrische Umwandlungsschicht (16), und
eine Elektronentransportschicht (14), wobei
die Elektronentransportschicht (14) Metalloxidpartikeln einschließt, und
als Reaktion auf die Durchführung einer Röntgen-Photoelektronen-Spektroskopie(XPS)-Analyse auf der Elektronentransportschicht, zwei Peaks erkannt werden, die 1s-Orbitalen von Sauerstoffatomen darstellen, und eine Formel Y / (X + Y) ≥ 0,5 erfüllt wird, worin eine Peakfläche eines Peaks auf einer Niedrigenergieseite unter den beiden Peaks X ist und eine Peakfläche eines Peaks auf einer Hochenergieseite unter den beiden Peaks Y ist.

2. Photoelektrische Umwandlungsvorrichtung nach Anspruch 1, wobei der zahlenmittlere Partikeldurchmesser der Metalloxidpartikeln 10 nm oder mehr und 50 nm oder weniger beträgt.

3. Photoelektrische Umwandlungsvorrichtung nach Anspruch 1 oder 2, wobei die Metalloxidpartikeln mindestens eines ausgewählt aus einer Gruppe bestehend aus Zinkoxid, Titanoxid und Zinnoxid als Bestandteilmaterial umfassen.

4. Photoelektrische Umwandlungsvorrichtung nach Anspruch 1 oder 2, wobei die Metalloxidpartikeln Zinkoxid als Bestandteilmaterial umfassen.

5. Photoelektrische Umwandlungsvorrichtung nach einem der Ansprüche 1 bis 4, wobei die Elektronentransportschicht ferner einen Metalloxidfilm umfasst, der zwischen den Metalloxidpartikeln angeordnet ist.

6. Photoelektrische Umwandlungsvorrichtung nach Anspruch 5, wobei der Metalloxidfilm mindestens eines ausgewählt aus einer Gruppe bestehend aus Zinkoxid, Titanoxid und Zinnoxid als Bestandteilmaterial umfasst.

7. Photoelektrische Umwandlungsvorrichtung nach Anspruch 5, wobei der Metalloxidfilm Zinkoxid als Bestandteilmaterial umfasst.

8. Photoelektrische Umwandlungsvorrichtung nach einem der Ansprüche 1 bis 7, wobei eine erste Elektrode (13), die Elektronentransportschicht, die photoelektrische Umwandlungsschicht, eine Lochtransportschicht und eine zweite Elektrode (18) in dieser Reihenfolge eingeschlossen sind.

9. Photoelektrische Umwandlungsvorrichtung nach Anspruch 8, wobei die erste Elektrode, die Elektronentransportschicht, eine Zwischenschicht, Schicht (15), die photoelektrische Umwandlungsschicht, die Lochtransportschicht und die zweite Elektrode in dieser Reihenfolge eingeschlossen sind.

10. Photoelektrische Umwandlungsvorrichtung nach einem der Ansprüche 1 bis 9, wobei die photoelektrische Umwandlungsschicht ein organisches Material mit einem höchsten besetzten Molekülorbital(HOMO)-Niveau von 5,1 eV oder mehr und 5,5 eV oder weniger und einer zahlenmittleren Molekülmasse (Mn) von 10 000 oder weniger enthält, wobei das HOMO-Niveau mittels Photoelektronen-Ausbeute-Spektroskopie gemessen wird.

11. Elektronische Vorrichtung, umfassend:
die photoelektrische Umwandlungsvorrichtung nach einem der Ansprüche 1 bis 10; und
eine Vorrichtung, die elektrisch mit der photoelektrischen Umwandlungsvorrichtung verbunden ist.

12. Elektronische Vorrichtung, umfassend:
die photoelektrische Umwandlungsvorrichtung nach einem der Ansprüche 1 bis 10;
eine elektrisch mit der photoelektrischen Umwandlungsvorrichtung verbundene Speicherbatterie; und
eine Vorrichtung, die elektrisch mit der photoelektrischen Umwandlungsvorrichtung und mit der Speicherbatterie verbunden ist.

13. Stromversorgungsmodul, umfassend:
die photoelektrische Umwandlungsvorrichtung nach einem der Ansprüche 1 bis 10; und
einen Stromversorgungs-IC, der elektrisch mit der photoelektrischen Umwandlungsvorrichtung verbunden ist.

14. Verfahren zum Herstellen einer photoelektrischen Umwandlungsvorrichtung, die eine Elektronentransportschicht (14) umfasst, wobei die Elektronentransportschicht Metalloxidpartikeln umfasst, wobei das Verfahren Folgendes umfasst:
Aufbringen einer Dispersionsflüssigkeit, die die Metalloxidpartikeln einschließt, um die Metalloxidpartikeln anzuordnen; und
Aufbringen einer Lösung, die einen Metalloxidvorläufer einschließt, der ein Vorläufer eines Metalloxids ist, auf die angeordneten Metalloxidpartikeln und Wandeln des Metalloxidvorläufers in das Metalloxid durch eine externe Stimulation.

15. Verfahren zum Herstellen einer photoelektrischen Umwandlungsvorrichtung, die eine Elektronentransportschicht (14) umfasst, wobei die Elektronentransportschicht Metalloxidpartikeln umfasst, wobei das Verfahren Folgendes umfasst:
Aufbringen einer gemischten Flüssigkeit, die die Metalloxidpartikeln und einen Metalloxidvorläufer enthält, der ein Vorläufer eines Metalloxids ist, um die Metalloxidpartikeln anzuordnen, und weiteres Wandeln des Metalloxid-Vorläufers in das Metalloxid durch eine externe Stimulation.

## Revendications

1. Dispositif de conversion photoélectrique (1) comprenant :
une couche de conversion photoélectrique (16), et
une couche de transport d'électrons (14), dans lequel
la couche de transport d'électrons (14) inclut des particules d'oxyde métallique, et
en réponse à la réalisation d'une analyse de spectroscopie de photoélectrons induits par rayons X (XPS) sur la couche de transport d'électrons, deux pics représentant des orbitales 1s d'atomes d'oxygène sont détectés, et une formule Y / (X + Y) ≥ 0,5 est satisfaite, où une aire de pic d'un pic sur un côté à faible énergie parmi les deux pics est X et une aire de pic d'un pic sur un côté à haute énergie parmi les deux pics.

2. Dispositif de conversion photoélectrique selon la revendication 1, dans lequel un diamètre de particule moyen en nombre des particules d'oxyde métallique est égal ou supérieur à 10 nm et inférieur ou égal à 50 nm.

3. Dispositif de conversion photoélectrique selon la revendication 1 ou 2, dans lequel les particules d'oxyde métallique comprennent au moins un oxyde sélectionné parmi un groupe constitué d'un oxyde de zinc, d'un oxyde de titane et d'un oxyde d'étain à titre de matériau constitutif.

4. Dispositif de conversion photoélectrique selon la revendication 1 ou 2, dans lequel les particules d'oxyde métallique comprennent de l'oxyde de zinc à titre de matériau constitutif.

5. Dispositif de conversion photoélectrique selon l'une quelconque des revendications 1 à 4, dans lequel la couche de transport d'électrons comprend en outre un film d'oxyde métallique disposé entre les particules d'oxyde métallique.

6. Dispositif de conversion photoélectrique selon la revendication 5, dans lequel le film d'oxyde métallique comprend au moins un oxyde sélectionné parmi un groupe constitué d'un oxyde de zinc, d'un oxyde de titane et d'un oxyde d'étain à titre de matériau constitutif.

7. Dispositif de conversion photoélectrique selon la revendication 5, dans lequel le film d'oxyde métallique comprend de l'oxyde de zinc à titre de matériau constitutif.

8. Dispositif de conversion photoélectrique selon l'une quelconque des revendications 1 à 7, dans lequel une première électrode (13), la couche de transport d'électrons, la couche de conversion photoélectrique, une couche de transport de trous, et une deuxième électrode (18) sont incluses consécutivement.

9. Dispositif de conversion photoélectrique selon la revendication 8, dans lequel la première électrode, la couche de transport d'électrons, une couche intermédiaire, couche (15), la couche de conversion photoélectrique, la couche de transport de trous, et la deuxième électrode sont incluses consécutivement.

10. Dispositif de conversion photoélectrique selon l'une quelconque des revendications 1 à 9, dans lequel la couche de conversion photoélectrique contient un matériau organique ayant un niveau d'orbitale moléculaire occupée la plus haute (HOMO) égal ou supérieur à 5,1 eV et inférieur ou égal à 5,5 eV et une masse moléculaire moyenne en nombre (Mn) égale ou inférieure à 10 000, le niveau de HOMO étant mesuré par spectroscopie de rendement en photoélectrons.

11. Dispositif électronique comprenant :
le dispositif de conversion photoélectrique selon l'une quelconque des revendications 1 à 10, et
un dispositif électriquement connecté au dispositif de conversion photoélectrique.

12. Dispositif électronique comprenant :
le dispositif de conversion photoélectrique selon l'une quelconque des revendications 1 à 10,
une batterie de stockage connectée électriquement au dispositif de conversion photoélectrique, et
un dispositif connecté électriquement au dispositif de conversion photoélectrique et à la batterie de stockage.

13. Module d'alimentation électrique comprenant :
le dispositif de conversion photoélectrique selon l'une quelconque des revendications 1 à 10, et
un CI d'alimentation électrique connecté électriquement au dispositif de conversion photoélectrique.

14. Procédé de fabrication d'un dispositif de conversion photoélectrique qui comprend une couche de transport d'électrons (14), la couche de transport d'électrons comprenant des particules d'oxyde métallique, le procédé comprenant :
l'application d'un liquide de dispersion incluant les particules d'oxyde métallique pour arranger les particules d'oxyde métallique, et
l'application d'une solution incluant un précurseur d'oxyde métallique, qui est un précurseur d'un oxyde métallique, sur les particules d'oxyde métallique arrangées et la transformation du précurseur d'oxyde métallique en l'oxyde métallique par une stimulation externe.

15. Procédé de fabrication d'un dispositif de conversion photoélectrique qui comprend une couche de transport d'électrons (14), la couche de transport d'électrons comprenant des particules d'oxyde métallique, le procédé comprenant :
l'application d'un liquide mélangé contenant les particules d'oxyde métallique et un précurseur d'oxyde métallique qui est un précurseur d'un oxyde métallique, pour arranger les particules d'oxyde métallique, et la transformation suivante du précurseur d'oxyde métallique en l'oxyde métallique par une stimulation externe.
